# EUROPEAN PATENT APPLICATION

(11) **EP 4 694 652 A1**
(43) Date of publication of application: **11.02.2026**
(21) Application number: 24781020.3
(22) Date of filing: 14.02.2024
(51) Int. Cl.: H10K 59/80, H10K 59/50, H10K 59/38, H10K 59/122, H10K 59/32, H10K 102/00

(54) **DISPLAY PANEL**

(30) Priority: 27.03.2023 KR 20230039714
(71) Applicant: Samsung Display Co., Ltd., Yongin-si, Gyeonggi-do 17113 (KR)
(72) Inventor: KIM, Jeongki, Yongin-si Gyeonggi-do 17113 (KR); KIM, Jang-Il, Yongin-si Gyeonggi-do 17113 (KR); KIM, Jong-hoon, Yongin-si Gyeonggi-do 17113 (KR); MIN, Kyounghae, Yongin-si Gyeonggi-do 17113 (KR); LEE, Seongyeon, Yongin-si Gyeonggi-do 17113 (KR); LEE, Sujin, Yongin-si Gyeonggi-do 17113 (KR)
(74) Representative: Dr. Weitzel & Partner
(86) International application number: PCT/KR2024/002100
(87) International publication number: WO 2024/205026

(57) **Abstract**

In an embodiment of the inventive concept provides a display panel that includes a light emitting element including a first electrode, an emission layer disposed on the first electrode, and a second electrode disposed on the emission layer and configured to output source light, and an optical structure layer disposed on the light emitting element, wherein the optical structure layer includes a light control layer disposed on the light emitting element and including at least one light control pattern, a low refractive layer disposed on the light control layer, and a barrier layer disposed between the light control layer and the low refractive layer and including silicon oxynitride (SiON), the barrier layer includes a first layer disposed adjacent to the low refractive layer and having nitrogen in an amount of less than about 1 at%, a second layer disposed spaced apart from the low refractive layer with the first layer therebetween, and having nitrogen in an amount of about 3 at% to about 30 at%, and a third layer disposed spaced apart from the low refractive layer with the first layer and the second layer therebetween, and having nitrogen in an amount of less than about 3.2 at%.

## Description

### [Technical Field]

The present disclosure herein relates to a display panel, and more particularly, to a display panel having improved durability and reliability and increased display efficiency.

### [Background Art]

A display panel includes a transmissive display panel that selectively transmits source light generated from a light source, and an emissive display panel that generates source light from a display panel itself. The display panel may include different types of color control pattern layers according to pixels to generate color images. The light control pattern layers may transmit only source light having a certain wavelength range or may convert the color of the source light. Some light control pattern layers may also change the characteristics of light without changing the color of the source light.

### [Disclosure]

### [Technical Problem]

Embodiments provide a display panel capable of improving durability, reliability, and display efficiency.

### [Technical Solution]

In an embodiment, a display panel may include a light emitting element that outputs source light, the light emitting element including a first electrode, an emission layer disposed on the first electrode, and a second electrode disposed on the emission layer, and an optical structure layer disposed on the light emitting element, wherein the optical structure layer may include a light control layer disposed on the light emitting element and including at least one light control pattern layer, a low refractive layer disposed on the light control layer, and a barrier layer disposed between the light control layer and the low refractive layer and including silicon oxynitride, the barrier layer may include a first layer adjacent to the low refractive layer and including nitrogen in an amount of less than about 1 at%, a second layer disposed on the first layer and spaced apart from the low refractive layer, and including nitrogen in an amount of about 3 at% to about 30 at%, and a third layer disposed on the second layer and spaced apart from the low refractive layer, and including nitrogen in an amount of less than about 3.2 at%.

In an embodiment, the third layer may have a refractive index of about 1.3 to about 1.5 with respect to light in a wavelength range of about 400 nm to about 700 nm.

In an embodiment, the first layer may be directly disposed on the low refractive layer, the second layer may be directly disposed on the first layer, and the third layer may be directly disposed on the second layer.

In an embodiment, the first layer may have a thickness of about 500 Å or greater.

In an embodiment, the optical structure layer may further include a color filter layer spaced apart from the light control layer with the low refractive layer between the color filter layer and the light control layer and including a plurality of color filters.

In an embodiment, the at least one light control pattern layer may include a first light control pattern layer that converts the source light into first light and a second light control pattern layer that transmits the source light, and the first light control pattern layer may include quantum dots that convert the source light into the first light.

In an embodiment, the light control layer may further include a bank adjacent to the at least one light control pattern layer, and the barrier layer may be directly disposed on the at least one light control pattern layer and the bank.

In an embodiment, the low refractive layer may include a base resin, and a plurality of hollow particles dispersed in the base resin.

In an embodiment, the low refractive layer may have a refractive index of about 1.3 or less with respect to light in a wavelength range of about 400 nm to about 700 nm.

In an embodiment, the second layer may include a (2-1)-th layer adjacent to the first layer, and a (2-2)-th layer disposed between the (2-1)-th layer and the third layer, and the (2-1)-th layer and the (2-2)-th layer may include different amounts of nitrogen from each other.

In an embodiment, the optical structure layer may further include an additional barrier layer spaced apart from the barrier layer with the light control layer between the additional barrier layer and the barrier layer, and the additional barrier layer may be directly disposed on the at least one light control pattern layer.

In an embodiment, the display panel may further include a filling layer disposed between the light emitting element and the optical structure layer and covering the light emitting element.

In an embodiment, the first layer may have a refractive index of about 1.3 to about 1.5 with respect to light in a wavelength range of about 400 nm to about 700 nm, and the second layer may have a refractive index of about 1.4 to about 1.8 with respect to light in a wavelength range of about 400 nm to about 700 nm.

In an embodiment, the third layer may be in contact with the at least one light control pattern layer.

In an embodiment, the light emitting element may include a plurality of light emitting stack members disposed between the first electrode and the second electrode, each of the plurality of light emitting stack members including the emission layer, the plurality of light emitting stack members may include a first light emitting stack member disposed on the first electrode and including a first emission layer, a charge generation layer disposed on the first light emitting stack member, and a second light emitting stack member disposed on the charge generation layer and including a second emission layer, and the first emission layer and the second emission layer may emit different color lights.

In an embodiment, a display panel may include a light emitting element that outputs source light, the light emitting element including a first electrode, an emission layer disposed on the first electrode, and a second electrode disposed on the emission layer, and an optical structure layer disposed on the light emitting element, wherein the optical structure layer may include a light control layer disposed on the light emitting element and including at least one light control pattern layer, a low refractive layer disposed on the light control layer, and a barrier layer disposed between the light control layer and the low refractive layer, the barrier layer may include a first layer, a second layer, and a third layer that are sequentially disposed from the low refractive layer, each of the first layer, the second layer, and the third layer including silicon oxynitride, the second layer may include an amount of nitrogen, which is about 3 times to about 60 times greater than the first layer, and the third layer may include nitrogen in an amount of less than about 3.2 at%.

In an embodiment, the first layer may be directly disposed on the low refractive layer, the second layer may be directly disposed on the first layer, and the third layer may be directly disposed on the second layer.

In an embodiment, a display panel may include a light emitting element that outputs source light, the light emitting element including a first electrode, an emission layer disposed on the first electrode, and a second electrode disposed on the emission layer, and an optical structure layer disposed on the light emitting element, wherein the optical structure layer may include a light control layer disposed on the light emitting element and including at least one light control pattern layer, a low refractive layer disposed on the light control layer, and a barrier layer disposed between the light control layer and the low refractive layer and including silicon oxynitride, the barrier layer may include a first layer directly disposed on the low refractive layer and including nitrogen in an amount of less than about 1 at%, a second layer directly disposed on the first layer, and including nitrogen in an amount of about 3 at% to about 30 at%, and a third layer directly disposed on the second layer, and the light control layer may be directly disposed below the third layer.

In an embodiment, the first layer may have a refractive index of about 1.3 to about 1.5 with respect to light in a wavelength range of about 400 nm to about 700 nm, the second layer may have a refractive index of about 1.4 to about 1.8 with respect to light in a wavelength range of about 400 nm to about 700 nm, and the third layer may have a refractive index of about 1.3 to about 1.5 with respect to light in a wavelength range of about 400 nm to about 700 nm.

In an embodiment, the first layer may have a thickness of about 500 Å or greater, the second layer may have a thickness of about 600 Å or greater, and the third layer may have a thickness of about 500 Å or greater.

### [Advantageous Effects]

According to the display panel of one embodiment of the present invention, the moisture and oxygen blocking properties and film durability of the barrier layer included in the light control layer can be improved, and the light conversion efficiency of the light control layer including the barrier layer can be improved. Accordingly, the reliability and display efficiency of the display panel including the light control layer can be improved.

### [Description of Drawings]

FIG. 1A is a perspective view of a display panel according to an embodiment of the inventive concept;
FIG. 1B is a cross-sectional view of a display panel according to an embodiment of the inventive concept;
FIG. 1C is a plan view of a display panel according to an embodiment of the inventive concept;
FIG. 2 is a plan view enlarging a portion of a display panel according to an embodiment of the inventive concept;
FIG. 3 is a cross-sectional view of a display panel according to an embodiment of the inventive concept;
FIG. 4A to 4C are views enlarging a partial region of a cross section of a display panel according to an embodiment of the inventive concept;
FIG. 5 is a cross-sectional view of a light emitting element according to an embodiment of the inventive concept;
FIG. 6A is a cross-sectional view of some components of a display panel according to an embodiment of the inventive concept;
FIG. 6B is a plan view enlarging some components of a display panel according to an embodiment of the inventive concept; and
FIG. 7 is a cross-sectional view of some components of a display panel according to an embodiment of the inventive concept.

### [Mode for Invention]

Hereinafter, embodiments of the inventive concept will be described with reference to the drawings.

As used herein, when an element (or a region, a layer, a portion, etc.) is referred to as being "on," "connected to," or "coupled to" another element, it means that the element may be directly connected to/coupled to the other element, or that a third element may be disposed therebetween.

Like numbers refer to like elements throughout. In addition, in the drawings, the thickness, the ratio, and the dimensions of elements are exaggerated for an effective description of technical contents. The term "and/or," includes all combinations of one or more of which associated configurations may define.

Although the terms first, second, etc. may be used herein to describe various elements, these elements should not be limited by these terms. These terms are only used to distinguish one element from another element. For example, a first element may be referred to as a second element, and similarly, a second element may be referred to as a first element without departing from the teachings of the present disclosure. The singular forms are intended to include the plural forms as well, unless the context clearly indicates otherwise.

In addition, terms such as "below," "lower," "above," "upper," and the like are used to describe the relationship of the configurations shown in the drawings. The terms are used as a relative concept and are described with reference to the direction indicated in the drawings.

It should be understood that the terms "comprise", or "have" are intended to specify the presence of stated features, integers, steps, operations, elements, components, or combinations thereof in the disclosure, but do not preclude the presence or addition of one or more other features, integers, steps, operations, elements, components, or combinations thereof.

As used herein, being "directly disposed on" may mean that there is no additional layer, film, region, plate, or the like between a part and another part such as a layer, a film, a region, a plate, or the like. For example, being "directly disposed on" may mean that two layers or two members are disposed without using an additional member such as an adhesive member, therebetween.

Unless otherwise defined, all terms (including technical and scientific terms) used herein have the same meaning as commonly understood by one of ordinary skill in the art to which the present disclosure belongs. In addition, terms, such as those defined in commonly used dictionaries, should be interpreted as having a meaning that is consistent with their meaning in the context of the relevant art and should not be interpreted in an idealized or overly formal sense unless expressly so defined herein.

Hereinafter, a display device according to an embodiment of the inventive concept will be described with reference to the accompanying drawings.

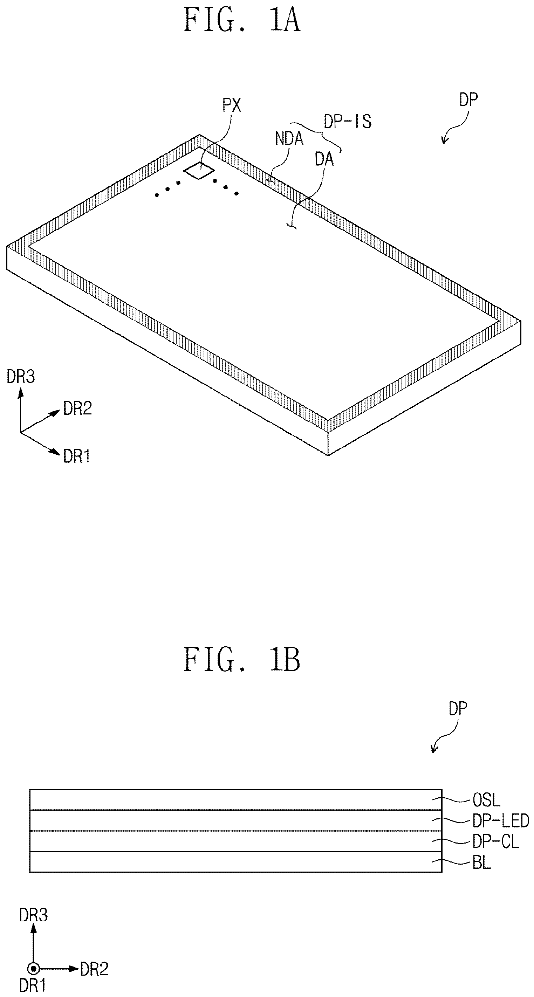

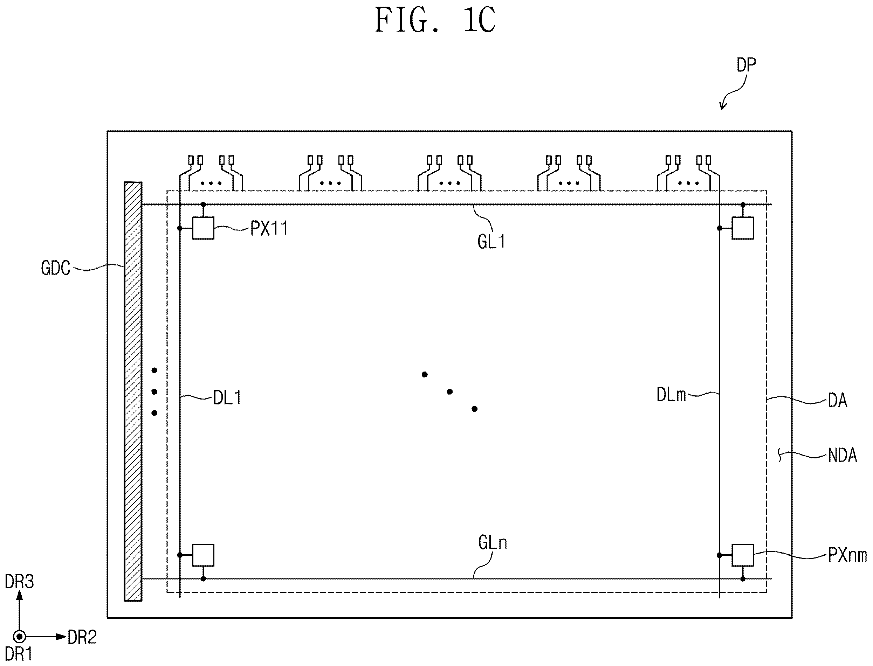

FIG. 1A is a perspective view of a display panel according to an embodiment of the inventive concept. FIG. 1B is a cross-sectional view of a display panel according to an embodiment of the inventive concept. FIG. 1C is a plan view of a display panel according to an embodiment of the inventive concept.

As shown in FIG. 1A, a display panel DP may display images through a display surface DP-IS. The display surface DP-IS is parallel to a plane defined by a first direction DR1 and a second direction DR2. The display surface DP-IS may include a display region DA and a non-display region NDA. A pixel PX is disposed in the display region DA, but is not disposed in the non-display region NDA. The non-display region NDA is defined along an edge of the display surface DP-IS. The non-display region NDA may surround the display region DA. However, the embodiment of the inventive concept is not limited thereto, and the non-display region NDA may be omitted or disposed on only one side of the display region DA.

A normal direction of the display surface DP-IS, that is, a thickness direction of the display panel DP is indicated by a third direction DR3. A front surface (or an upper surface) and a rear surface (or a lower surface) of respective layers or units which will be described below are separated by the third direction DR3. However, the first to third directions DR1, DR2, and DR3 shown in the present embodiment are merely examples.

In an embodiment of the inventive concept, the display panel DP having a planar front surface DP-IS is shown, but the embodiment of the inventive concept is not limited thereto. The display panel DP may include a curved display surface or a three-dimensional display surface. The three-dimensional display surface may include a plurality of display regions indicating different directions.

As shown in FIG. 1B, the display panel DP includes a base substrate BS, a circuit element layer DP-CL, a display element layer DP-LED, and an optical structure layer OSL. The base substrate BS may include a synthetic resin substrate or a glass substrate. The circuit element layer DP-CL includes at least one insulating layer and a circuit element. The circuit element includes a signal line, a driving circuit of a pixel, and the like. The circuit element layer DP-CL may be formed through a process of forming an insulating layer, a semiconductor layer, and a conductive layer by coating, vapor deposition, and the like, and a process of patterning the insulating layer, the semiconductor layer, and the conductive layer by photolithography. The display element layer DP-LED includes at least one display element. The optical structure layer OSL may convert the color of light provided from the display element. The optical structure layer OSL may include a light control pattern and a structure for increasing light conversion efficiency.

FIG. 1C shows a planar arrangement relationship of signal lines GL1 to GLn and DL1 to DLm and pixels PX11 to PXnm. The signal lines GL1 to GLn and DL1 to DLm may include a plurality of gate lines GL1 to GLn and a plurality of data lines DL1 to DLm.

Each of the pixels PX11 to PXnm is connected to a corresponding gate line among the plurality of gate lines GL1 to GLn and a corresponding data line among the plurality of data lines DL1 to DLm. Each of the pixels PX11 to PX may include a pixel driving circuit and a display element. More various types of signal lines may be provided in the display panel DP according to the configuration of the pixel driving circuits of the pixels PX11 to PXnm.

Although the pixels PX11 to PXnm arranged in a matrix form are shown as an example, the embodiment of the inventive concept is not limited thereto. The pixels PX11 to PXnm may be arranged in a Pentile^{®} form. For example, points at which the pixels PX11 to PXnm are disposed may correspond to vertices of a diamond. A gate driving circuit GDC may be integrated on the display panel DP through an oxide silicon gate (OSG) driver circuit process or an amorphous silicon gate (ASG) driver circuit process.

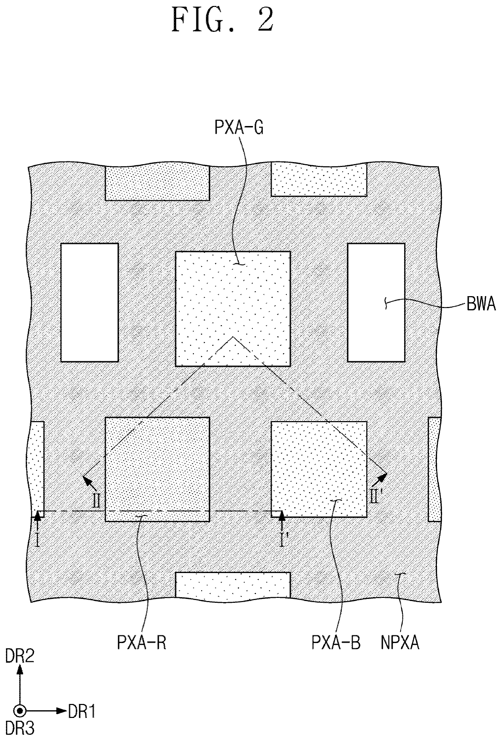

FIG. 2 is a plan view enlarging a portion of a display panel according to an embodiment of the inventive concept. FIG. 2 shows, as an example, a plane including three pixel regions PXA-R, PXA-B, and PXA-G and a bank well region BWA adjacent thereto in the display panel DP according to an embodiment of the inventive concept. In an embodiment of the inventive concept, the three types of pixel regions PXA-R, PXA-B, and PXA-G shown in FIG. 2 may be repeatedly disposed throughout the display region DA (see FIG. 1A).

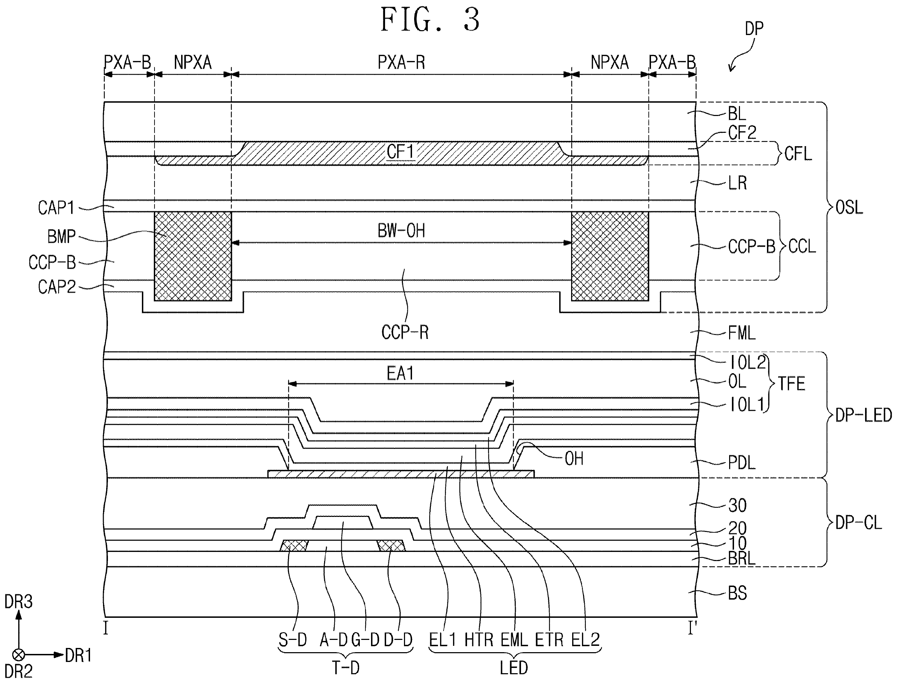

A peripheral region NPXA is disposed around the first to third pixel regions PXA-R, PXA-B, and PXA-G. The peripheral region NPXA sets boundaries between the first to third pixel regions PXA-R, PXA-B, and PXA-G. The peripheral region NPXA may surround the first to third pixel regions PXA-R, PXA-B, and PXA-G. A structure that prevents color mixing between the first to third pixel regions PXA-R, PXA-B, and PXA-G, for example, a pixel defining film PDL (see FIG. 3) or a bank BMP (see FIG. 3) may be disposed in the peripheral region NPXA.

FIG. 2A shows, as an example, the first to third pixel regions PXA-R, PXA-B, and PXA-G having the same planar shape and having different planar areas, but the embodiment of the inventive concept is not limited thereto. Areas of at least two of the first to third pixel regions PXA-R, PXA-B, and PXA-G may be equal to each other. Areas of the first to third pixel regions PXA-R, PXA-B, and PXA-G may be set according to the color of emitted light. The pixel region that emits light of red color among primary colors may have the largest area, and the pixel region that emits light of blue color among primary colors may have the smallest area.

FIG. 2 shows the first to third pixel regions PXA-R, PXA-B, and PXA-G having a rectangular shape, but the embodiment of the inventive concept is not limited thereto. When viewed on a plane, the first to third pixel regions PXA-R, PXA-B, and PXA-G may have other polygonal shapes (including substantially polygonal shapes) such as a rhombus or a pentagon. In an embodiment, the first to third pixel regions PXA-R, PXA-B, and PXA-G may have a rectangular shape (a substantially rectangular shape) having rounded corners when viewed on a plane.

FIG. 2 shows that the third pixel region PXA-G is disposed in a first row, and the first pixel region PXA-R and the second pixel region PXA-B are disposed in a second row, but the embodiment of the inventive concept is not limited thereto. The arrangement of the first to third pixel regions PXA-R, PXA-B, and PXA-G may be variously changed. For example, the first to third pixel regions PXA-R, PXA-B, and PXA-G may be arranged in the same row.

One among the first to third pixel regions PXA-R, PXA-B, and PXA-G provides second light corresponding to a source light, another provides first light different from the second light, and the other provides third light different from the first light and the second light. In the present embodiment, the second pixel region PXA-B provides the second light corresponding to the source light. In the present embodiment, the first pixel region PXA-R may provide red light, the second pixel region PXA-B may provide blue light, and the third pixel region PXA-G may provide green light.

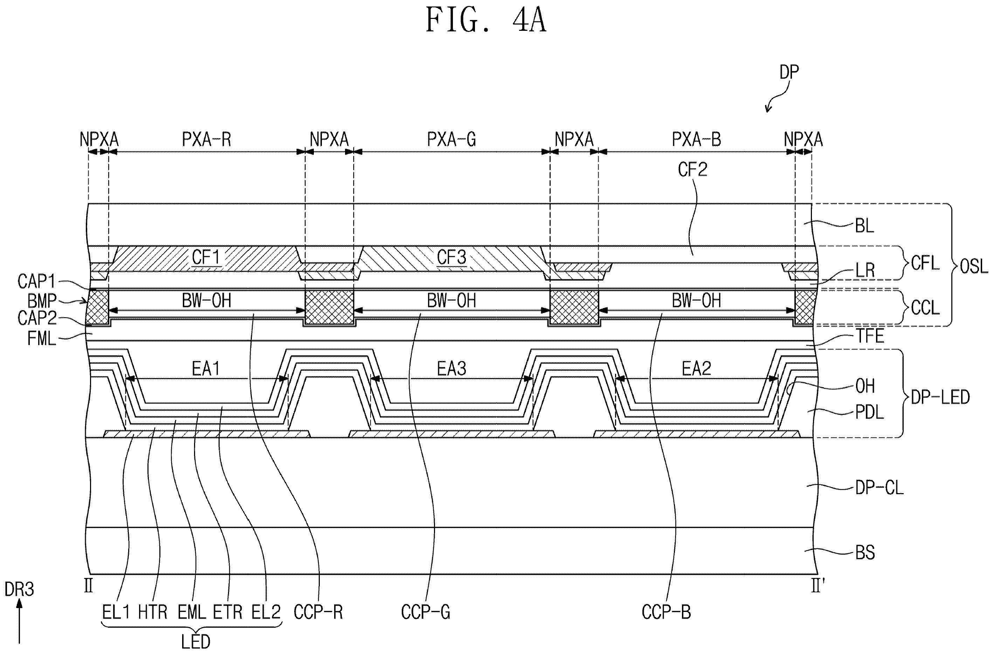

The bank well region BWA may be defined in the display region DA (see FIG. 1A). The bank well region BWA may be a region in which the bank well BW (ass FIG. 3) is formed in order to prevent defects due to erroneous adhesion in the process of patterning the plurality of light control patterns CCP-R, CCP-B, CCP-G (see FIG. 4A) included in the light control layer CCL (see FIG. 4A). That is, the bank well region BWA may be a region in which a bank well formed by removing a portion of the bank BMP (see FIG. 4A) is defined.

FIG. 2 shows, as an example, that the two bank well regions BWA are defined to be adjacent to the third pixel regions PXA-G, but the embodiment of the inventive concept is not limited thereto, and the shape and arrangement of the bank well regions BWA may be variously changed.

FIG. 3 is a cross-sectional view of a display panel according to an embodiment of the inventive concept. FIG. 4A is a view enlarging a partial region of a cross-section of a display panel according to an embodiment of the inventive concept. FIG. 3 is a cross-sectional view of a light emitting element included in a display panel according to an embodiment of the inventive concept. FIG. 3 shows a cross section corresponding to line II' of FIG. 2. FIG. 4A shows a cross section corresponding to line II-II' of FIG. 2.

Referring to FIG. 3, the display panel DP according to an embodiment may include a base substrate BS, a circuit element layer DP-CL disposed on the base substrate BS, and a display element layer DP-LED disposed on the circuit element layer DP-CL. As used herein, the base substrate BS, the circuit element layer DP-CL, and the display element layer DP-LED may be collectively referred to as a lower panel.

The base substrate BS may be a member that provides a base surface on which components included in the circuit element layer DP-CL are disposed. In an embodiment, the base substrate BS may be a glass substrate, a metal substrate, a polymer substrate, or the like. However, the embodiment of the inventive concept is not limited thereto, and the base substrate BS may be an inorganic layer, a functional layer, or a composite material layer.

The base substrate BS may have a multilayer structure. For example, the base substrate BS may have a three-layer structure of a polymer resin layer, an adhesive layer, and a polymer resin layer. In particular, the polymer resin layer may include a polyimide-based resin. In addition, the polymer resin layer may include at least one of an acrylic resin, a methacrylic resin, a polyisoprene-based resin, a vinyl-based resin, an epoxy-based resin, a urethane-based resin, a cellulose-based resin, a siloxane-based resin, a polyamide-based resin, or a perylene-based resin. Meanwhile, as used herein, an "a-based" resin may be considered as including a functional group of "a".

The circuit element layer DP- CL may be disposed on the base substrate BS. The circuit element layer DP-CL may include a transistor T-D as a circuit element. The configuration of the circuit element layer DP-CL may vary according to the design of the driving circuit of the pixel PX (see FIG. 1A), and one transistor T-D is shown in FIG. 3 as an example. An arrangement relationship of an active A-D, a source S-D, a drain D-D, and a gate G-D, which constitute the transistor T-D, are shown by way of example. The active A-D, the source S-D, and the drain D-D may be regions divided according to the doping concentration or conductivity of the semiconductor pattern.

The circuit element layer DP-CL may include a lower buffer layer BRL, a first insulating layer 10, a second insulating layer 20, and a third insulating layer 30 that are disposed on the base substrate BS. For example, the lower buffer layer BRL, the first insulating layer 10, and the second insulating layer 20 may be inorganic layers, and the third insulating layer 30 may be an organic layer.

The display element layer DP-LED may include a light emitting element LED as a display element. The light emitting element LED may generate the source light described above. The light emitting element LED includes a first electrode EL1, a second electrode EL2, and an emission layer EML disposed therebetween. In the present embodiment, the light emitting element DP-LED may include an organic light emitting diode as a light emitting element. In an embodiment of the inventive concept, the light emitting element may include a quantum dot light emitting diode. That is, the emission layer EML included in the light emitting element LED may include an organic light emitting material as a light emitting material, or the emission layer EML may include quantum dots as a light emitting material. Alternatively, In the present embodiment, the display element layer DP-LED may include an ultra-small light emitting element to be described later as a light emitting element. The ultra-small light emitting element may include, for example, a micro LED element and/or nano LED element, and the like. The micro light emitting element may be a light emitting element having a micro- or nano-scale size and including an active layer disposed between a plurality of semiconductor layers.

The first electrode EL1 is disposed on the third insulating layer 30. The first electrode EL1 may be directly or indirectly connected to the transistor T-D, and a connection structure between the first electrode EL1 and the transistor T-D is not shown in FIG. 3.

The display element layer DP-LED includes the pixel defining film PDL. For example, the pixel defining film PDL may be an organic layer. A light emitting opening OH is defined in the pixel defining film PDL. The light emitting opening OH of the pixel defining film PDL allows at least a portion of the first electrode EL1 to be exposed. In the present embodiment, a first light emitting region EA1 may be defined by the light emitting opening OH.

A hole control layer HTR, the emission layer EML, and an electron control layer ETR overlap at least the pixel region PXA-R. Each of the hole control layer HTR, the emission layer EML, the electron control layer ETR, and the second electrode EL2 may be disposed, in common, in the first to third pixel regions PXA-R, PXA- B, and PXA-G (see FIG. 4A). Each of the hole control layer HTR, the emission layer EML, the electron control layer ETR, and the second electrode EL2 that overlap the first to third pixel regions PXA-R, PXA-B, and PXA-G (FIG. 4A) may have an integral shape. However, the embodiment of the inventive concept is not limited thereto, and at least one of the hole control layer HTR, the emission layer EML, or the electron control layer ETR may be formed separately for each of the first to third pixel regions PXA-R, PXA-B, and PXA-G (see FIG. 4A). In an embodiment, the emission layer EML may be patterned in the light emitting opening OH, and formed separately for each of the first to third pixel regions PXA-R, PXA-B, and PXA-G (see FIG. 4A).

The hole control layer HTR may include a hole transport layer and may further include a hole injection layer.

The emission layer EML may generate the third light that is the source light. The emission layer EML may generate blue light. The blue light may include light having a wavelength of about 410 nm to about 480 nm. An emission spectrum of the blue light may have a maximum peak in a wavelength range of about 440 nm to about 460 nm.

The electron control layer ETR may include an electron transport layer and may further include an electron injection layer.

The display element layer DP-LED may include a thin film encapsulation layer TFE that protects the second electrode EL2. The thin film encapsulation layer TFE may include an organic material or an inorganic material. The thin film encapsulation layer TFE may have multilayer structure in which an inorganic layer and an organic layer are repeated. In the present embodiment, the thin film encapsulation layer TFE may include a first inorganic encapsulation layer IOL1/an organic encapsulation layer OL/a second inorganic encapsulation layer IOL2. The first and second inorganic encapsulation layers IOL1 and IOL2 may protect the light emitting element LED from external moisture, and the organic encapsulation layer OL may prevent dent defects on the light emitting element LED caused by foreign substances introduced during the manufacturing process. Although not shown, the display panel DP may further include a refractive index control layer on an upper side of the thin film encapsulation layer TFE to improve light output efficiency.

As shown in FIG. 3, the optical structure layer OSL is disposed on the thin film encapsulation layer TFE. The optical structure layer OSL may include a light control layer CCL, a low refractive layer LR, a color filter layer CFL, and a base layer BL. As used herein, the optical structure layer OSL may be referred to as an upper panel.

The light control layer CCL may be disposed on the display element layer DP-LED including the light emitting element LED. The light control layer CCL includes a bank BMP, light control patterns CCP-R and CCP-B, and a barrier layer CAP1.

The bank BMP may include a base resin and an additive. The base resin may be formed of various resin compositions, which may be generally referred to as a binder. The additive may include a coupling agent and/or a photo-initiator. The additive may further include a dispersant.

The bank BMP may include a black coloring agent to block light. The bank BMP may include a black dye or black pigment mixed with a base resin. In an embodiment, the black coloring agent may include carbon black, a metal such as chromium, or an oxide thereof.

The bank BMP includes a bank opening BW-OH corresponding to the light emitting opening OH. When viewed on a plane, the bank opening BW-OH overlaps the light emitting opening OH and has a larger area than the light emitting opening OH. That is, the bank opening BW-OH may have a larger area than the light emitting region EA1 defined by the light emitting opening OH. Meanwhile, as used herein, the wording "corresponding" means that the two components overlap when viewed in the thickness direction DR3 of the display panel DP, and is not limited to the two components having the same area.

The light control patterns CCP-R and CCP-B are disposed inside the bank opening BW-OH. At least some of the light control patterns CCP-R and CCP-B may change optical properties of the source light. In an embodiment, the first light control pattern CCP-R may change optical properties of the source light.

The first light control pattern CCP-R may include quantum dots for changing the optical properties of the source light. The first light control pattern CCP-R may include quantum dots that convert the source light into light having a different wavelength. In the light control pattern CCP-R overlapping the first pixel region PXA-R, the quantum dots may convert blue light, which is the source light, into red light.

In the present description, a quantum dot indicates a crystal of a semiconductor compound. The quantum dot may emit light of various emission wavelengths depending on the size of the crystal. The quantum dot may emit light of various emission wavelengths by regulating an element ratio in the quantum dot compound.

The quantum dot may have a diameter of, for example, about 1 nm to about 10 nm.

The quantum dot may be synthesized through a wet chemical process, a metal organic chemical vapor deposition process, a molecular beam epitaxy process, or a process similar thereto.

The wet chemical process is a method of mixing an organic solvent and a precursor material and then growing a quantum dot particle crystal. When the crystal grows, the organic solvent naturally serves as a dispersant coordinated to a surface of the quantum dot crystal and may control the growth of the crystal. Therefore, the wet chemical process is easier than vapor deposition methods such as metal organic chemical vapor deposition (MOCVD) or molecular beam epitaxy (MBE), and may control the growth of quantum dot particles through a low-cost process.

A core of the quantum dot may be selected from a Group II-VI compound, a Group III-V compound, a Group III-VI compound, a Group I-III-VI compound, a Group IV-VI compound, a Group IV element, a Group IV compound, and a combination thereof.

The Group II-VI compound may be selected from the group consisting of a binary compound selected from the group consisting of CdSe, CdTe, CdS, ZnS, ZnSe, ZnTe, ZnO, HgS, HgSe, HgTe, MgSe, MgS, and a mixture thereof, a ternary compound selected from the group consisting of CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and a mixture thereof, and a quaternary compound selected from the group consisting of HgZnTeS, CdZnSeS, CdZnSeTe, CdZnSTe, CdHgSeS, CdHgSeTe, CdHgSTe, HgZnSeS, HgZnSeTe, HgZnSTe, and a mixture thereof. Meanwhile, the Group II-VI semiconductor compound may further include a Group I metal and/or a Group IV element. The Group I-II-VI compound may be selected from CuSnS or CuZnS, and the Group II-IV-VI compound may be selected from ZnSnS and the like. The Group I-II-IV-VI compound may be selected from quaternary compounds selected from the group consisting of Cu2ZnSnS2, Cu2ZnSnS4, Cu2ZnSnSe4, Ag2ZnSnS2, and a mixture thereof.

The Group III-VI compound may include a binary compound such as In2S3 and In2Se3, a ternary compound such as InGaS3 and InGaSe3, or any combination thereof.

The Group I-III-VI compound may be selected from a ternary compound selected from the group consisting of AglnS, AglnS2, CulnS, CulnS2, AgGaS2, CuGaS2 CuGaO2, AgGaO2, AgAlO2, or a mixture thereof, or a quaternary compound such as AglnGaS2 and CulnGaS2.

The Group III-V compound may be selected from the group consisting of a binary compound selected from the group consisting of GaN, GaP, GaAs, GaSb, AIN, AlP, AlAs, AlSb, InN, InP, InAs, InSb, and a mixture thereof, a ternary compound selected from the group consisting of GaNP, GaNAs, GaNSb, GaPAs, GaPSb, AINP, AlNAs, AlNSb, AlPAs, AlPSb, InGaP, InAlP, InNP, InNAs, InNSb, InPAs, InPSb, and a mixture thereof, and a quaternary compound selected from the group consisting of GaAlNP, GaAINAs, GaAINSb, GaAlPAs, GaAlPSb, GalnNP, GalnNAs, GalnNSb, GalnPAs, GalnPSb, InAlNP, InAINAs, InAlNSb, InAlPAs, InAlPSb, and a mixture thereof. Meanwhile, the Group III-V compound may further include a Group II metal. For example, InZnP and the like may be selected as a Group III-II-V compound.

The Group IV-VI compound may be selected from the group consisting of a binary compound selected from the group consisting of SnS, SnSe, SnTe, PbS, PbSe, PbTe, and a mixture thereof, a ternary compound selected from the group consisting of SnSeS, SnSeTe, SnSTe, PbSeS, PbSeTe, PbSTe, SnPbS, SnPbSe, SnPbTe, and a mixture thereof, and a quaternary compound selected from the group consisting of SnPbSSe, SnPbSeTe, SnPbSTe, and a mixture thereof.

Examples of the Group II-IV-V semiconductor compound may be a ternary compound selected from the group consisting of ZnSnP, ZnSnP2, ZnSnAs2, ZnGeP2, ZnGeAs2, CdSnP2, and CdGeP2 and a mixture thereof.

The Group IV element may be selected from the group consisting of Si, Ge, and a mixture thereof. The Group IV compound may be a binary compound selected from the group consisting of SiC, SiGe, and a mixture thereof.

Each element included in the multi-element compound such as the binary compound, ternary compound, and quaternary compound may be present in particles at a uniform concentration or a non-uniform concentration. That is, Formula above indicates the types of elements included in a compound, and element ratios in the compound may be different. For example, AglnGaS2 may indicate AglnxGa1-xS2 (x is a real number between 0 and 1).

In this case, the binary compound, the ternary compound, or the quaternary compound may be present in particles having a uniform concentration distribution, or may be present in the same particles having a partially different concentration distribution. In addition, a core/shell structure in which one quantum dot surrounds another quantum dot may be present. The core/shell structure may have a concentration gradient in which the concentration of an element present in the shell becomes lower towards the core.

In some embodiments, a quantum dot may have the core/shell structure including a core having nano-crystals, and a shell surrounding the core, which are described above. The shell of the quantum dot may serve as a protection layer to prevent the chemical deformation of the core so as to keep semiconductor properties, and/or a charging layer to impart electrophoresis properties to the quantum dot. The shell may be a single layer or multiple layers. Examples of the shell of the quantum dot may be a metal or non-metal oxide, a semiconductor compound, or a combination thereof.

For example, the metal or non-metal oxide may be a binary compound such as SiO2, Al203, TiO2, ZnO, MnO, Mn2O3, Mn3O4, CuO, FeO, Fe2O3, Fe3O4, CoO, Co3O4, NiO, or a ternary compound such as MgAl2O4, CoFe2O4, NiFe2O4, and CoMn204, but the embodiment of the inventive concept is not limited thereto.

In addition, the semiconductor compound may be, for example, CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, and the like, but the embodiment of the inventive concept is not limited thereto.

The quantum dot may have, in an emission wavelength spectrum, a full width of half maximum (FWHM) of about 45 nm or less, preferably about 40 nm or less, and more preferably about 30 nm or less, and in this range, the color purity or the color reproducibility may be improved. In addition, light emitted through the quantum dot is emitted in all directions, and thus a wide viewing angle may be improved.

In addition, the form of a quantum dot is not particularly limited as long as it is a form commonly used in the art, but more specifically, a quantum dot in the form of spherical, pyramidal, multi-arm, or cubic nanoparticles, nanotubes, nanowires, nanofibers, nanoplatelets, and the like may be used.

As the size of the quantum dot or the ratio of elements in the quantum dot compound is regulated, the energy band gap may be accordingly controlled to obtain light of various wavelengths from the quantum dot emission layer. Therefore, by using the quantum dots as described above (using quantum dots of different sizes or having different element ratios in the quantum dot compound), a light emitting element emitting light of various wavelengths may be obtained. Specifically, the size of the quantum dots or the ratio of elements in the quantum dot compound may be regulated to emit red, green, and/or blue light. In addition, the quantum dots may be configured to emit white light by combining light of various colors.

In an embodiment, the quantum dots included in the first light control pattern CCP-R overlapping the first pixel region PXA-R may have a red emission color. The smaller the particle size of the quantum dot becomes, light in the short wavelength region may be emitted. For example, among the quantum dots with the same core, the particle size of the quantum dots that emit green light may be smaller than the particle size of the quantum dots that emit red light. In addition, among the quantum dots with the same core, the particle size of quantum dots that emit blue light may be smaller than the particle size of quantum dots that emit green light. However, the embodiment of the inventive concept is not limited thereto, and even in the quantum dots having the same core, the particle size may be controlled according to a shell forming material and a shell thickness.

Meanwhile, when the quantum dots have various emission colors such as blue, red, and green, the quantum dots having different emission colors may have different core materials.

The first light control pattern CCP-R may further include scatterers. The first light control pattern CCP-R may include quantum dots that convert blue light into red light, and scatterers that scatter light.

The scatterer may be an inorganic particle. For example, the scatterer may include at least one among TiO2, ZnO, Al2O3, SiO2, and hollow silica. The scatterers may include any one of TiO2, ZnO, Al2O3, SiO2, or hollow silica, or a mixture of two or more materials selected from among TiO2, ZnO, Al2O3, SiO2, and hollow silica.

The first light control pattern CCP-R may include a base resin for dispersing the quantum dots and the scatterers. The base resin may be a medium in which the quantum dots and the scatterers are dispersed, and may be formed of various resin compositions which may be generally referred to as a binder. For example, the base resin may be an acrylic resin, a urethane-based resin, a silicon-based polymer, an epoxy-based resin, and the like. The base resin may be a transparent resin.

In the present embodiment, the first light control pattern CCP-R may be formed through an inkjet process. A liquid composition is provided in the bank opening BW-OH. A composition that is polymerized by a thermal curing process or a photo-curing process is reduced in volume after curing.

A stepped portion may be generated between a lower surface of the bank BMP and a lower surface of the first light control pattern CCP-R. That is, the lower surface of the bank BMP may be defined to be higher than the lower surface of the first light control pattern CCP-R. A difference in height between the lower surface of the bank BMP and the lower surface of the first light control pattern CCP-R may be, for example, about 2 µm to about 3 µm.

The light control layer CCL includes a barrier layer CAP1 disposed on one surface of the first light control pattern CCP-R. The barrier layer CAP1 may serve to prevent penetration of moisture and/or oxygen (hereinafter, referred to as 'moisture/oxygen') and improve optical properties of the optical structure layer OSL by regulating a refractive index. The barrier layer CAP1 may be disposed on one upper surface or one lower surface of the first light control pattern CCP-R to prevent the first light control pattern CCP-R to be exposed to moisture/oxygen, and in particular, to prevent quantum dots included in the first light control pattern CCP-R to be exposed to moisture/oxygen. The barrier layer CAP1 may also protect the first light control pattern CCP-R from external impact.

In an embodiment, the barrier layer CAP1 may be disposed spaced apart from the display element layer DP-LED with the first light control pattern CCP-R therebetween. That is, the barrier layer CAP1 may be disposed on the upper surface of the first light control pattern CCP-R. In an embodiment, the light control layer CCL may include an additional barrier layer CAP2 disposed between the first light control pattern CCP-R and the display element layer DP-LED. The barrier layer CAP1 may cover the upper surface of the first light control pattern CCP-R adjacent to the low refractive layer LR, and the additional barrier layer CAP2 may cover the lower surface of the first light control pattern CCP-R adjacent to the display element layer DP-LED. Meanwhile, as used herein, the "upper surface" may be a surface placed on an upper portion with respect to the third direction DR3, and the "lower surface" may be a surface place on a lower portion with respect to the third direction DR3.

In addition, the barrier layer CAP1 and the additional barrier layer CAP2 may cover one surface of the bank BMP as well as the first light control pattern CCP-R.

The barrier layer CAP1 may cover one surface of the first light control pattern CCP-R and the bank BMP adjacent to the low refractive layer LR. The barrier layer CAP1 may be directly disposed below a low refractive layer LR. The additional barrier layer CAP2 may be disposed to follow a stepped portion between the bank BMP and the first light control pattern CCP-R. The additional barrier layer CAP2 may be directly disposed above a filling layer FML.

The barrier layer CAP1 and the additional barrier layer CAP2 may include an inorganic material. In the display panel DP according to an embodiment, the barrier layer CAP1 includes silicon oxynitride (SiON). Both the barrier layer CAP1 and the additional barrier layer CAP2 may include silicon oxynitride. However, the embodiment of the inventive concept is not limited thereto, and the barrier layer CAP1 disposed above the first light control pattern CCP-R may include silicon oxynitride and the additional barrier layer CAP2 disposed below the first light control pattern CCP-R may include silicon oxide (SiOx). However, the embodiment of the inventive concept is not limited thereto.

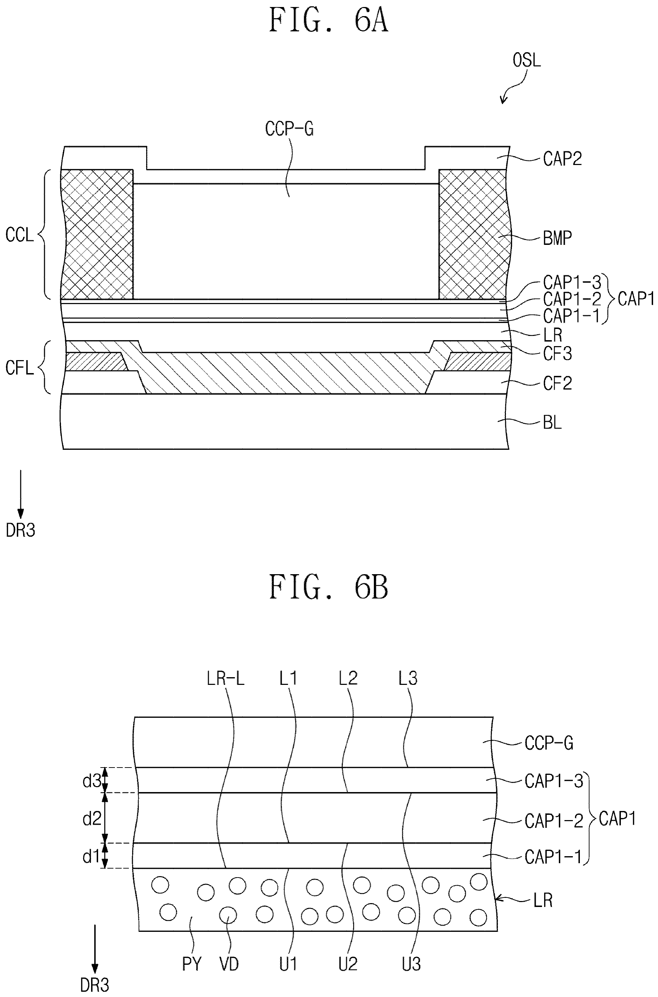

The barrier layer CAP1 including silicon oxynitride limits an amount of silicon, oxygen, and nitrogen in the silicon oxynitride film to a certain range to prevent moisture/oxygen from penetrating into the first light control pattern CCP-R, increases film durability, and have a refractive index range that does not reduce light efficiency of a display panel. Hereinafter, the amount and detailed stacked structure of the barrier layer CAP1 according to an embodiment will be described in more detail in the description of FIGS. 6A and 6B.

The color filter layer CFL is disposed on the light control layer CCL. The color filter layer CFL includes at least one color filter. The color filter transmits light having a specific wavelength range and blocks light having a wavelength other than the specific wavelength range. A first color filter CF1 of the first pixel region PXA-R may transmit red light and block green light and blue light.

The first color filter CF1 includes a base resin and a dye and/or pigment dispersed in the base resin. The base resin is a medium in which dyes and/or pigments are dispersed, and may be formed of various resin compositions that may be generally referred to as binders.

The first color filter CF1 may have a uniform thickness in the first pixel region PXA-R. The light, obtained by converting the source light, which is blue light, into red light through the light control pattern CCP-R, may be provided to the outside with uniform luminance in the first pixel region PXA-R.

The optical structure layer OSL includes the low refractive layer LR. The low refractive layer LR may be disposed between the light control layer CCL and the color filter layer CFL. The low refractive layer LR may be disposed above the light control layer CCL to prevent the first light control pattern CCP-R from being exposed to moisture/oxygen. In addition, the low refractive layer LR may serve as an optical functional layer that is disposed between the first light control pattern CCP-R and the first color filter CF1 to increase light extraction efficiency or prevent reflected light from being incident on the light control layer CCL. The low refractive layer LR may have a smaller refractive index than a layer adjacent thereto.

The low refractive layer LR may include at least one inorganic layer. For example, the low refractive layer LR may be formed including silicon nitride, aluminum nitride, zirconium nitride, titanium nitride, hafnium nitride, tantalum nitride, silicon oxide, aluminum oxide, titanium oxide, tin oxide, cerium oxide, silicon oxynitride, or a metal thin film in which light transmittance is secured, etc. However, the embodiment is not limited thereto, and the low refractive layer LR may include an organic layer. The low refractive layer LR may have, for example, a structure in which a plurality of hollow particles are dispersed in an organic polymer resin. The low refractive layer LR may be formed of a single layer or a plurality of layers.

In an embodiment, the display panel DP may further include a base layer BL disposed on the color filter layer CFL. The base layer BL may be a member that provides a base surface on which the color filter layer CFL, the low refractive layer LR, the light control layer CCL, and the like are disposed. The base layer BL may be a glass substrate, a metal substrate, a plastic substrate, and the like. However, an embodiment is not limited thereto, and the base layer BL may be an inorganic layer, an organic layer, or a composite material layer. In addition, unlike what is shown, the base layer BL may be omitted in an embodiment.

Although not shown, an anti-reflection layer may be disposed on the base layer BL. The anti-reflection layer may be a layer that reduces the reflectance of external light incident from the outside. The anti-reflection layer may be a layer that selectively transmits light emitted from the display panel DP. In an embodiment, the anti-reflection layer may be a single layer including a dye and/or a pigment dispersed in a base resin. The anti-reflection layer may be provided as one continuous layer that overlaps the entire surfaces of the first to third pixel regions PXA-R, PXA-B, and PXA-G (see FIG. 4A).

The anti-reflection layer may not include a polarizing layer. Accordingly, light that passes through the anti-reflection layer and is incident on the side of the display element layer DP-LED may be unpolarized light. The display element layer DP-LED may receive unpolarized light from above the anti-reflection layer.

The display panel DP according to an embodiment may include a lower panel having a display element layer DP-LED, and an upper panel (optical structure layer, OSL) including the light control layer CCL and the color filter layer CFL. In an embodiment, a filling layer FML may be disposed between the lower panel and the upper panel OSL. In an embodiment, the filling layer FML may fill a space between the display element layer DP-LED and the light control layer CCL. The filling layer FML may be directly disposed on the encapsulation layer TFE, and the additional barrier layer CAP2 may be directly disposed on the filling layer FML. A lower surface of the filling layer FML may contact an upper surface of the encapsulation layer TFE, and an upper surface of the filling layer FML may contact a lower surface of the additional barrier layer CAP2 CAP.

The filling layer FML may function as a buffer between a display element layer DP-LED and the light control layer CCL. In an embodiment, the filling layer FML may have a shock absorbing function, etc., and may increase the strength of the display panel DP. The filling layer FML may be formed from a filler resin including a polymer resin. For example, the filling layer FML may be formed from a filling layer resin including an acrylic resin or an epoxy-based resin.

The filling layer FML may have a component distinct from the encapsulation layer TFE disposed therebelow and the additional barrier layer CAP2 disposed thereabove, and the filling layer FML, the encapsulation layer TFE and the first barrier layer CAP may be respectively formed through separate processes. Meanwhile, the filling layer FML may be formed of a material different from those of the encapsulation layer TFE and the additional barrier layer CAP2.

Referring to FIG. 4A, the display panel DP may include a base substrate BS and a circuit element layer DP-CL disposed on the base substrate BS. The circuit element layer DP-CL may be disposed on the display substrate BS. The circuit layer DP-CL may include an insulating layer, a semiconductor pattern, a conductive pattern, a signal line, and the like. The insulating layer, the semiconductor layer, and the conductive layer are formed on the base layer BS through a coating or deposition method, and subsequently, the insulating layer, the semiconductor layer, and the conductive layer may be selectively patterned by performing a photolithography process multiple time. Then, the semiconductor pattern, the conductive pattern, and the signal line included in the circuit element layer DP-CL may be formed. In an embodiment, the circuit element layer DP-CL may include a transistor, a buffer layer, and a plurality of insulating layers.

A light emitting element LED according to an embodiment may include a first electrode EL1, a second electrode EL2 facing the first electrode EL1, and an emission layer EML disposed between the first electrode EL1 and the second electrode EL2. The emission layer EML included in the light emitting element LED may include an organic light emitting material or quantum dots as a light emitting material. The light emitting element LED may further include the hole control layer HTR and the electron control layer ETR. Meanwhile, although not shown, the light emitting element LED may further include a capping layer (not shown) disposed on the second electrode EL2.

The pixel defining film PDL may be disposed on the circuit element layer DP-CL and cover a portion of the first electrode EL1. A light emitting opening OH is defined in the pixel defining film PDL. The light emitting opening OH of the pixel defining film PDL allows at least a portion of the first electrode EL1 to be exposed. In the present embodiment, the light emitting regions EA1, EA2, and EA3 are defined corresponding to a partial region of the first electrode EL1 exposed by the opening portion OH.

The display element layer DP-LED may include a first light emitting region EA1, a second light emitting region EA2, and a third light emitting region EA3. The first light emitting region EA1, the second light emitting region EA2, and the third light emitting region EA3 may be regions divided by the pixel defining film PDL. The first light emitting region EA1, the second light emitting region EA2, and the third light emitting region EA3 may respectively correspond to a first pixel region PXA-R, a second pixel region PXA-B, and a third pixel region PXA-G.

The light emitting regions EA1, EA2, and EA3 may overlap the pixel regions PXA-R, PXA-B, and PXA-G and may not overlap the bank well region BWA. When viewed on a plane, the area of the pixel regions PXA-R, PXA-B, and PXA-G divided by the bank BMP may be larger than the area of the light emitting regions EA1, EA2, and EA3 divided by the pixel defining film PDL.

In the light emitting element LED, the first electrode EL1 is disposed on the circuit element layer DP-CL. The first electrode EL1 may be an anode or cathode. In addition, the first electrode EL1 may be a pixel electrode. The first electrode EL1 may be a transmissive electrode, a transflective electrode, or a reflective electrode.

The hole control layer HTR may be disposed between the first electrode EL1 and the emission layer EML. The hole control layer HTR may include at least one of a hole injection layer, a hole transport layer, or an electron blocking layer. The hole control layer HTR may be disposed as a common layer to overlap the light emitting regions EA1, EA2, and EA3 and the entirety of the pixel defining films PDL that separate the light emitting regions EA1, EA2, and EA3. However, the embodiment of the inventive concept is not limited thereto, and the hole control layer HTR may be provided through patterning so that the hole control layer HTR is separately disposed corresponding to each of the light emitting regions EA1, EA2, and EA3.

The emission layer EML is disposed on the hole control layer HTR. In an embodiment, the emission layer EML may be provided as a common layer to overlap the light emitting regions EA1, EA2, and EA3 and the entirety of the pixel defining films PDL that separate the light emitting regions EA1, EA2, and EA3. In an embodiment, the emission layer EML may emit blue light. The emission layer EML may overlap all of the hole control layer HTR and the electron control layer ETR.

However, the embodiment of the inventive concept is not limited thereto, and in an embodiment, the emission layer EML may be disposed in the light emitting opening OH. That is, the emission layers EML may be separately formed to correspond to the light emitting regions EA1, EA2, and EA3 which are separated by the pixel defining films PDL. All of the emission layers EML formed separately to correspond to the light emitting regions EA1, EA2, and EA3 may emit blue light or may emit light having different wavelength ranges.

The emission layer EML may have a single layer formed of a single material, a single layer formed of a plurality of materials different from each other, or a multilayered structure that has a plurality of layers formed of a plurality of materials different from each other. The emission layer EML may include a fluorescent or phosphorescent material. In the light emitting element according to an embodiment, the emission layer EML may include an organic light emitting material, a metal organic complex, or quantum dots as a light emitting material. Meanwhile, FIGS. 3 and 4A show, as an example, a light emitting element LED including one emission layer EML, but in an embodiment, the light emitting element may include a plurality of light emitting stacks each having at least one emission layer.

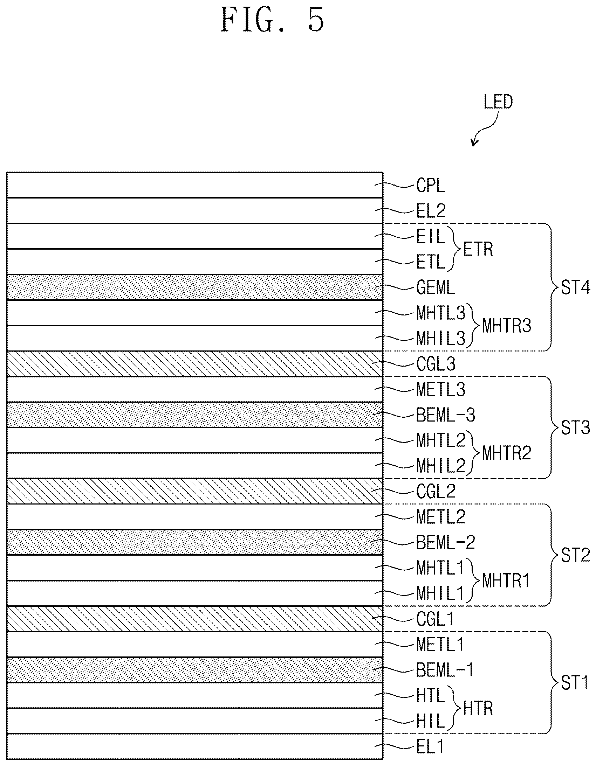

FIG. 5 is a cross-sectional view of a light emitting element according to an embodiment of the inventive concept. FIG. 5 shows, as an example, a light emitting element LED including a plurality of light emitting stacks ST1, ST2, ST3, and ST4, unlike the light emitting element according to an embodiment shown in FIGS. 3 and 4A.

Referring to FIG. 5, a light emitting element LED according to an embodiment may include a first electrode EL1, a second electrode EL2 facing the first electrode EL1, and the first to fourth light emitting stacks ST1, ST2, ST3, and ST4 disposed between the first electrode EL1 and the second electrode EL2. Meanwhile, although FIG. 5 shows, as an example, that the light emitting element LED includes four light emitting stacks, the number of light emitting stacks included in the light emitting element LED may be less than or more than four.

The light emitting element LED may include first to third charge generation layers CGL1, CGL2, and CGL3 disposed between the first to fourth light emitting stacks ST1, ST2, ST3, and ST4.

When a voltage is applied to the first to third charge generation layers CGL1, CGL2, and CGL3, charges (electrons and holes) may be generated by forming a complex through an oxidation-reduction reaction. In addition, each of the first to third charge generation layers CGL1, CGL2, and CGL3 may provide the generated charges to the adjacent stacks ST1, ST2, ST3, and ST4. The first to third charge generation layers CGL1, CGL2, and CGL3 may double an efficiency of the current generated in each of the adjacent stacks ST1, ST2, ST3, and ST4, and may serve to adjust the balance of the charges between the adjacent stacks ST1, ST2, ST3, and ST4.

The first to third charge generation layers CGL1, CGL2, and CGL3 may respectively include an n-type layer and a p-type layer. The first to third charge generation layers CGL1, CGL2, and CGL3 may have a structure in which an n-type layer and a p-type layer are joined to each other. However, the embodiment of the inventive concept is not limited thereto, and the first to third charge generation layers CGL1, CGL2, and CGL3 may include only one of an n-type layer or a p-type layer. The n-type layer may be a charge generation layer that provides electrons to adjacent stacks. The n-type layer may be a layer in which a base material is doped with an n-dopant. The p-type layer may be a charge generation layer that provide holes to adjacent stacks.

In an embodiment, each of the first to third charge generation layers CGL1, CGL2, and CGL3 may have a thickness of about 1 angstrom (Å) to about 150 angstroms (Å). The concentration of the n-dopant doped with the first to third charge generation layers CGL1, CGL2, and CGL3 may be about 0.1% to about 3%, and specifically may be about 1%. When the concentration of the dopant is less than about 0.1%, the effect of the first to third charge generation layers CGL1, CGL2, and CGL3 for adjusting the balance of charges may be hardly achieved. When the concentration of the dopant is greater than about 3%, the light efficiency of the light emitting element LED may be reduced.

The first to third charge generation layers CGL1, CGL2, and CGL3 may respectively include a charge generation compound composed of an arylamine-based organic compound, a metal, a metal oxide, a metal carbide, a metal fluoride, or a mixture thereof. For example, the arylamine-based organic compound may include α-NPD, 2-TNATA, TDATA, MTDATA, sprio-TAD, or sprio-NPB. The metal may include cesium (Cs), molybdenum (Mo), vanadium (V), titanium (Ti), tungsten (W), barium (Ba), or lithium (Li). The metal oxide, metal carbide, and metal fluoride may include Re2O7, MoO3, V2O5, WO3, TiO2, Cs2CO3, BaF, LiF, or CsF. However, materials of the first to third charge generation layers CGL1, CGL2, and CGL3 are not limited to the above examples.

Each of the first to fourth light emitting stacks ST1, ST2, ST3, and ST4 may include an emission layer. The first light emitting stack ST1 may include a first emission layer BEML-1, the second light emitting stack ST2 may include a second emission layer BEML-2, the third light emitting stack ST3 may include a third emission layer BEML-3, and the fourth light emitting stack ST4 may include a fourth emission layer GEML. Some of the emission layers included in the first to fourth light emitting stacks ST1, ST2, ST3, and ST4 may emit light of substantially the same color, and some may emit light of different colors.

In an embodiment, the first to third emission layers BEML-1, BEML-2, and BEML-3 of the first to third light emitting stacks ST1, ST2, and ST3 may emit substantially the same first color light. For example, the first color light may be blue light, which is the above-described source light. The wavelength range of the light emitted from the first to third emission layers BEML-1, BEML-2, and BEML-3 may be about 420 nm to about 480 nm.

The fourth emission layer GEML of the fourth light emitting stack ST4 may emit a second color light different from the first color light. For example, the second color light may be green light. The wavelength range of the light emitted from the fourth emission layer GEML may be about 520 nm to about 600 nm.

At least a portion of the first to fourth emission layers BEML-1, BEML-2, BEML-3, and GEML may have a two-layer structure including different host materials. For example, in the two-layer structure, one layer may include a hole-transporting host material, and the other layer may include an electron-transporting host material. The electron-transporting host material may be a material containing an electron-transporting moiety in a molecular structure.

The first light emitting stack ST1 may further include the hole control layer HTR that transports holes provided from the first electrode EL1 to the first emission layer BEML-1, and a first intermediate electron control layer METL1 that transport electrons generated from a first charge generation layer CGL1 to the first emission layer BEML-1.

The hole control layer HTR may include a hole injection layer HIL disposed on the first electrode EL1, and a hole transport layer HTL disposed on the hole injection layer HIL. However, the embodiment of the inventive concept is not limited thereto, and the hole control layer HTR may further include at least one of a hole buffer layer, an emission auxiliary layer, or an electron blocking layer. The hole buffer layer may compensate a resonance distance according to wavelengths of light emitted from an emission layer, and may thus increase luminous efficiency. The electron blocking layer is a layer that serves to prevent electrons from being injected from an electron control layer to a hole control layer.

The first intermediate electron control layer METL1 may include the first intermediate electron transport layer disposed on the first emission layer BEML-1. However, the embodiment of the inventive concept is not limited thereto, and the first intermediate electron control layer METL1 may further include at least one of an electron buffer layer or a hole blocking layer.

The second light emitting stack ST2 may include a first intermediate hole control layer MHTR1 that transports holes generated from the first charge generation layer CGL1 to the second emission layer BEML-2 and a second intermediate electron control layer METL2 that transports electrons provided from a second charge generation layer CGL2 to the second emission layer BEML-2.

The first intermediate hole control layer MHTR1 may include a first intermediate hole injection layer MHIL1 disposed on the first charge generation layer CGL1, and a first intermediate hole transport layer MHTL1 disposed on the first intermediate hole injection layer MHIL1. The first intermediate hole control layer MHTR1 may further include at least one of a hole buffer layer, an emission auxiliary layer, or an electron blocking layer which is disposed on the first intermediate hole transport layer MHTL1.

The second intermediate electron control layer METL2 may include a second intermediate electron transport layer disposed on the second emission layer BEML-2. However, the embodiment of the inventive concept is not limited thereto, and the second intermediate electron control layer METL2 may further include at least one of an electron buffer layer or a hole blocking layer which is disposed between the second intermediate electron transport layer and the second emission layer BEML-2.

The third light emitting stack ST3 may include a second intermediate hole control layer MHTR2 that transports holes generated from a second charge generation layer CGL2 to the third emission layer BEML-3, and a third intermediate electron control layer METL3 that transports electrons provided from a third charge generation layer CGL3 to the third emission layer BEML-3.

The second intermediate hole control layer MHTR2 may include a second intermediate hole injection layer MHIL2 disposed on the second charge generation layer CGL2, and a second intermediate hole transport layer MHTL2 disposed on the second intermediate hole injection layer MHIL2. However, the embodiment of the inventive concept is not limited thereto, and the second intermediate hole control layer MHTR2 may further include at least one of a hole buffer layer, an emission auxiliary layer, or an electron blocking layer which is disposed on the second intermediate hole transport layer MHTL2.

The third intermediate electron control layer METL3 may include a third intermediate electron transport layer disposed on the third emission layer BEML-3. However, the embodiment of the inventive concept is not limited thereto, and the third intermediate electron control layer METL3 may further include at least one of an electron buffer layer or a hole blocking layer, which is disposed between the third intermediate electron transport layer and the third emission layer BEML-3.

The fourth light emitting stack ST4 may further include a third intermediate hole control layer MHTR3 that transports holes generated from the third charge generation layer CGL3 to the fourth emission layer GEML, and the electron control layer ETR that transports electrons provided from the second electrode EL2 to the fourth emission layer GEML.

The third intermediate hole control layer MHTR3 may include a third intermediate hole injection layer MHIL3 disposed on the third charge generation layer CGL3, and a third intermediate hole transport layer MHTL3 disposed on the third intermediate hole injection layer MHIL3. However, the embodiment of the inventive concept is not limited thereto, and the third intermediate hole transport control layer MHTR3 may further include at least one of a hole buffer layer, an emission auxiliary layer, or an electron blocking layer, which is disposed on the third intermediate hole transport layer MHTL3.

The electron control layer ETR may include an electron transport layer ETL disposed on the fourth emission layer GEML and an electron injection layer EIL disposed on the electron transport layer ETL. However, the embodiment of the inventive concept is not limited thereto, and the electron control layer ETR may further include at least one of an electron buffer layer or a hole blocking layer which is disposed between the electron transport layer ETL and the fourth emission layer GEML.

In an embodiment, the light emitting element LED may emit light in a direction from the first electrode EL1 to the second electrode EL2, and based on the direction in which the light is emitted, the hole control layer HTR may be disposed below the plurality of light emitting stacks ST1, ST2, ST3, and ST4, and the electronic control layer ETR may be disposed above the plurality of light emitting stacks ST1, ST2, ST3, and ST4. However, the embodiment of the inventive concept is not limited thereto, and based on the light emitting direction, the light emitting element may have an inverted element structure in which the electron control layer ETR is disposed below the plurality of stacks ST1, ST2, ST3, and ST4 and the hole control layer HTR is disposed above the plurality of stack ST1, ST2, ST3, and ST4.

Referring back to FIG. 4A, the electronic control layer ETR may be disposed between the emission layer EML and the second electrode EL2. The electron control layer ETR may include at least one of an electron injection layer, an electron transport layer, or a hole blocking layer. Referring to FIG. 4A, the electron control layer ETR may be disposed as a common layer to overlap the light emitting regions EA1, EA2, and EA3 and the entirety of the pixel defining films PDL that separate the light emitting regions EA1, EA2, and EA3. However, the embodiment of the inventive concept is not limited thereto, and the electron control layer ETR may be provided through patterning so that the electron control layer ETR is separately disposed corresponding to each of the light emitting regions EA1, EA2, and EA3.

The second electrode EL2 is provided on the electronic control layer ETR. The second electrode EL2 may be a common electrode. The second electrode EL2 may be a cathode or an anode but the embodiment of the inventive concept is not limited thereto. For example, when the first electrode EL1 is an anode, the second electrode EL2 may be a cathode, and when the first electrode EL1 is a cathode, the second electrode EL2 may be an anode. The second electrode EL2 may be a transmissive electrode, a transflective electrode, or a reflective electrode.

The encapsulation layer TFE may be disposed on the display element layer LED. For example, in an embodiment, the encapsulation layer TFE may be disposed on the second electrode EL2. In addition, when the light emitting element LED includes a capping layer (not shown), the encapsulation layer TFE may be disposed on the capping layer (not shown). As described above, the encapsulation layer TFE may include at least one organic film and at least one inorganic film, and the inorganic film and the organic film may be alternately disposed.

The display panel DP according to an embodiment may include an optical structure layer OSL disposed on the display element layer DP-LED. The optical structure layer OSL may include a light control layer CCL, a color filter layer CFL, and a base layer BL.

The light control layer CCL may include a light converter. The light converter may be quantum dots or phosphors. The light converter may wavelength-convert the provided light and emit the wavelength-converted light. That is, the light control layer CCL may be a layer including the quantum dots or a layer including the phosphors at least in part.

The light control layer CCL may include a plurality of light control patterns CCP-R, CCP-B, and CCP-G. The light control patterns CCP-R, CCP- B, and CCP-G may be spaced apart from each other. The light control patterns CCP-R, CCP-B, and CCP-G may be disposed to be spaced apart from each other by the bank BMP. The light control patterns CCP-R, CCP-B, and CCP-G may be disposed in the bank opening BW-OH defined in the bank BMP. However, the embodiment of the inventive concept is not limited thereto. FIG. 4A shows that the bank BMP has a rectangular shape in cross-section and does not overlap the light control patterns CCP-R, CCP-B, and CCP-G. However, at least a portion of the edges of the light control patterns CCP-R, CCP-B, and CCP-G may overlap the bank BMP. The bank BMP may have a trapezoidal shape in cross-section. As the bank BMP is more adjacent to the display element layer DP-LED, the cross-sectional width may become greater.

The light control patterns CCP-R, CCP-B, and CCP-G may be portions that convert the wavelength of light provided from the display element layer DP-LED or transmit the provided light. The light control patterns CCP-R, CCP-B, and CCP-G may be formed by an inkjet process. A liquid ink composition may be provided in the bank openings BW-OH, and the provided ink composition may be polymerized by a thermal curing process or a photo-curing process to form the light control patterns CCP-R, CCP-B, and CCP-G.

The light control layer CCL may include a first light control pattern CCP-R having first quantum dots that converts the source light provided from the light emitting element LED into the first light, a second light control pattern CCP-B that transmits the source light, and a third light control pattern CCP-G including second quantum dots that converts the source light into the second light.

In an embodiment, the first light control pattern CCP-R may provide red light, which is the first light, and the second light control pattern CCP-B may be provided by transmitting blue light, which is the source light, among the source light provided by the light emitting element LED. The third light control pattern CCP-G may provide green light, which is the second light. For example, the first quantum dots may be red quantum dots, and the second quantum dots may be green quantum dots.

In addition, the light control layer CCL may further include the scatterers. The first light control pattern CCP-R includes the first quantum dots and the scatterers, the third light control pattern CCP-G includes the second quantum dots and the scatterers, and the second light control pattern CCP-B may not include the quantum dots and include the scatterers.

Each of the first light control pattern CCP-R, the second light control pattern CCP-B, and the third light control pattern CCP-G may include a base resin for dispersing the quantum dots and the scatterers. In an embodiment, the first light control pattern CCP-R may include the first quantum dots and the scatterers dispersed in a base resin, the third light control pattern CCP-G may include the second quantum dots and the scatterers dispersed in the base resin, and the second light control pattern CCP-B may include the scatterers dispersed in the base resin.

The light control layer CCL includes the barrier layer CAP1 disposed on one surface of a light control portion. The light control layer CCL may include the barrier layer CAP1 spaced apart from the display element layer DP-LED with the light control pattern CCP-R therebetween, and the additional barrier layer CAP2 adjacent to the display element layer DP-LED.

In the display panel DP, the optical structure layer OSL includes the color filter layer CFL disposed on the light control layer CCL. The color filter layer CFL may include color filters CF1, CF2, and CF3. The color filter layer CFL may include a first color filter CF1 that transmits the first light, a second color filter CF2 that transmits the source light, and a third color filter CF3 that transmits the second light. In an embodiment, the first color filter CF1 may be a red filter, the second color filter CF2 may be a blue filter, and the third color filter CF3 may be a green filter.

Each of the filters CF1, CF2, and CF3 includes a polymer photosensitive resin and a colorant. The first color filter CF1 may contain a red colorant, the second color filter CF2 may contain a blue colorant, and the third color filter CF3 may contain a green colorant. The first color filter CF1 may include a red pigment or a red dye, the second color filter CF2 may include a blue pigment or a blue dye, and the third color filter CF3 may include a green pigment or a green dye.

The first to third color filters CF1, CF2, and CF3 may respectively correspond to the first pixel region PXA-R, the second pixel region PXA-B, and the third pixel region PXA-G. In addition, the first to third color filters CF1, CF2, and CF3 may respectively correspond to the first light control pattern to third light control pattern CCP-R, CCP-B, and CCP-G.

In addition, the plurality of color filters CF1, CF2, and CF3 that transmit different light corresponding to the peripheral region NPXA disposed between the pixel regions PXA-R, PXA-B, and PXA-G may be disposed to overlap each other. The plurality of color filters CF1, CF2, and CF3 may be overlapped in the third direction DR3, which is the thickness direction, to separate a boundary between the adjacent pixel regions PXA-R, PXA-B, and PXA-G. Meanwhile, unlike what is shown, the color filter layer CFL may include a light blocking portion (not shown) for dividing a boundary between the adjacent color filters CF1, CF2, and CF3. The light blocking portion (not shown) may be formed of a blue filter or may include an organic light blocking material or an inorganic light blocking material that includes a black pigment or a black dye.

The optical structure layer OSL may include a low refractive index layer LR disposed between the light control layer CCL and the color filter layer CFL. The low refractive layer LR may be disposed between the light control patterns CCP-R, CCP-B, and CCP-G and the color filters CF1, CF2, and CF3. The low refractive layer LR may be disposed on the upper portion of the light control layer CCL to block the light control pattern CCP-R, CCP-B, and CCP-G from being exposed to moisture/oxygen. In addition, the low refractive layer LR may serve as an optical functional layer that is disposed between the light control pattern CCP-R, CCP-B, and CCP-G and the color filters CF1, CF2, and CF1 to increase light extraction efficiency or prevent reflected light from being incident on the light control layer CCL. The low refractive layer LR may have a smaller refractive index than other layers adjacent thereto.

The low refractive layer LR may include at least one inorganic layer. For example, the low refractive layer LR may be formed including silicon nitride, aluminum nitride, zirconium nitride, titanium nitride, hafnium nitride, tantalum nitride, silicon oxide, aluminum oxide, titanium oxide, tin oxide, cerium oxide, silicon oxynitride, or a metal thin film in which light transmittance is secured, etc. However, the embodiment is not limited thereto, and the low refractive layer LR may include an organic layer. The low refractive layer LR may have, for example, a structure in which a plurality of hollow particles are dispersed in an organic polymer resin. The low refractive layer LR may be formed of a single layer or a plurality of layers.

In an embodiment, the optical structure layer OSL may further include a base layer BL disposed on the color filter layer CFL. The base layer BL may be a member that provides a base surface on which the color filter layer CFL, the light control layer CCL, and the like are disposed. The base layer BL may be a glass substrate, a metal substrate, a plastic substrate, and the like. However, an embodiment is not limited thereto, and the base layer BL may be an inorganic layer, an organic layer, or a composite material layer. In addition, unlike what is shown, the base layer BL may be omitted in an embodiment.

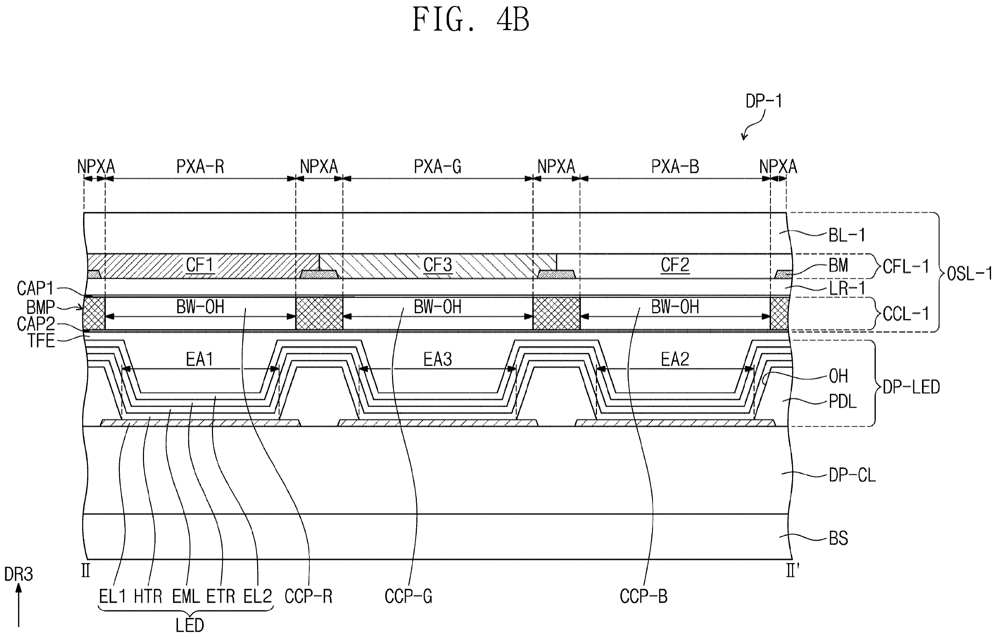

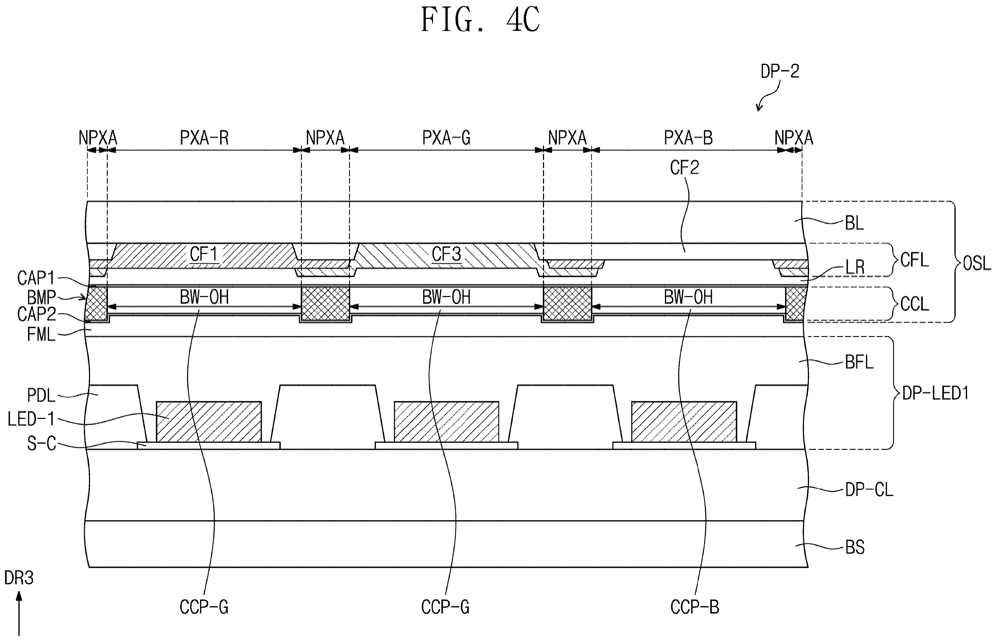

FIG. 4B and FIG. 4C are each a view enlarging a partial region of a cross-section of a display panel according to an embodiment of the inventive concept. FIG. 4B and FIG. 4C each show the display panel DP of an embodiment shown in FIG. 4A and display panels DP-1 and DP-2 of other embodiments.

Referring to FIG. 4B, the display panel DP-1 according to an embodiment may include a base substrate BS, a circuit element layer DP-CL disposed on the base substrate BS, a lower panel including the display element layer DP-LED disposed on the circuit element layer DP-CL, and an optical structure layer OSL-1 disposed on the lower panel. In the display panel DP-1 according to an embodiment, the optical structure layer OSL-1 may include a light control layer CCL-1 sequentially stacked on the thin film encapsulation layer TFE, a low refractive layer LR-1, a color filter layer CFL-1, and a base layer BL-1. The optical structure layer OSL-1 may include a barrier layer CAP1 and an additional barrier layer CAP2 disposed on upper and lower surfaces of the light control layer CCL-1.

The light control layer CCL-1 may be disposed on the display element layer DP-LED and the thin film encapsulation layer TFE with the additional barrier layer CAP2 therebetween. The light control layer CCL-1 may include a plurality of banks BMP and light control portions CCP-B, CCP-G, and CCP-R disposed between the banks BMP. The low refractive layer LR may be disposed on the light control layer CCL-1.

The color filter layer CFL-1 may include a plurality of color filters CF1, CF2, and CF3, and a light blocking portion BM.

Compared to the display panel DP shown in FIG. 4A, the display panel DP-1 according to an embodiment shown in FIG. 4B is an embodiment in which the light control layer CCL-1, the low refractive layer LR, and the color filter layer CFL-1 are disposed using an upper surface of the thin film encapsulation layer TFE as the base surface. That is, the light control portions CCP-B, CCP-G, and CCP-R of the light control layer CCL-1 may be formed on the thin film encapsulation layer TFE through a roll-to-roll process, and the filters CF1, CF2, and CF3 of the color filter layer CFL-1 may be sequentially formed on the light control layer CCL-1 through a roll-to-roll process. The light control layer CCL-1 may be formed using an upper surface of the additional barrier layer CAP2 disposed on the thin film encapsulation layer TFE as a base surface, and may thus have a shape in which the light control layer CCL shown in FIG. 4A is vertically inverted. Specifically, the plurality of banks BMP and the plurality of light control portions CCP-B, CCP-G, and CCP-R may each have a shape in which what is shown in FIG. 4A is vertically inverted. The color filter layer CFL-1 may be formed using an upper surface of the light control layer CCL-1 as a base surface, and may thus have a different shape from what is shown in FIG. 4A.

In the color filter layer CFL-1 according to an embodiment, the light blocking portion BM may be a black matrix. The light blocking portion BM may be formed including an organic light blocking material or an inorganic light blocking material, both including a black pigment or a black dye. The light blocking portion BM may prevent light leakage, and separate boundaries between the adjacent color filters CF-B, CF-G, and CF-R.

Referring to FIG. 4C, the display element layer DP-ED1 included in the display panel DP-2 according to an embodiment may include a light emitting element LED-1, and the light emitting element LED-1 may be a micro LED element or a Nano LED element. The light emitting element LED-1 may be disposed between the pixel defining films PDL and electrically connected to a contact portion S-C, and the light emitting element LED-1 may have a length and a width of several hundred nanometers to several hundred micrometers. The light emitting element LED-1 may be an LED element including an active layer and at least one semiconductor material layer. The light emitting element LED-1 may further include an insulating layer covering surfaces of the active layer and the semiconductor material layer. The light emitting element LED-1 may be patterned and disposed to overlap each of the pixel regions PXA-R, PXA-B, and PXA-G. The display panel DP may include a buffer layer BFL disposed on the light emitting element LED-1. The buffer layer BFL may be disposed on the light emitting element LED-1 to cover the light emitting element LED-1. Meanwhile, in the display panel DP-2 of an embodiment shown in FIG. 4C, the buffer layer BFL may be omitted.

FIG. 6A is a cross-sectional view of some components of a display panel according to an embodiment of the inventive concept. FIG. 6B is a plan view enlarging some components of a display panel according to an embodiment of the inventive concept. FIG. 6A enlarges and shows some components of the light control layer CCL, the barrier layer CAP1, the additional barrier layer CAP2, and the low refractive layer LR, and the color filter layer CFL included in the optical structure layer OSL of the display panel DP according to an embodiment. In FIG. 6B, the barrier layer CAP1 shown in FIG. 6A and the components adjacent thereto are simply enlarged and shown. Hereinafter, in describing the barrier layer CAP1 included in the optical structure layer OSL of an embodiment through FIGS. 6A and 6B, the third light control pattern CCP-G is referred to as a "light control pattern". Meanwhile, in FIGS. 6A and 6B, the components shown in FIGS. 3 and 4A are rotated by 180°, and thus the upper surface based on FIGS. 6A and 6B s referred to as the "lower surface" and the lower surface s referred to as the "upper surface".

Referring to FIGS. 3, 4A, 6A, and 6B, as described above, the optical structure layer OSL includes the barrier layer CAP1 disposed on one surface of the light control pattern CCP-G. The barrier layer CAP1 may be disposed between the light control pattern CCP-G and the low refractive layer LR. That is, the barrier layer CAP1 may be disposed on an upper surface of the light control pattern CCP-G.

The barrier layer CAP1 may be directly disposed on upper surfaces of the light control pattern CCP-G and the bank BMP. That is, the barrier layer CAP1 may contact the upper surfaces of the light control pattern CCP-G and the bank BMP.

The barrier layer CAP1 may be disposed between the light control pattern CCP-G and the low refractive layer LR, and may be directly disposed below the low refractive layer LR. The barrier layer CAP1 may contact a lower surface LR-L of the low refractive layer LR.

The barrier layer CAP1 has a multi-layer structure, and a plurality of layers each included in the barrier layer CAP1 includes silicon oxynitride (SiON). The barrier layer CAP1 may have a structure of a plurality of layers that are distinguished from each other with interfaces defined therebetween. The barrier layer CAP1 has a multi-layer structure and limits a composition ratio of silicon, oxygen, and nitrogen in a plurality of silicon oxynitride films to a certain range to prevent moisture/oxygen from penetrating into the first light control pattern CCP-R, increases film durability, and have a refractive index range that does not reduce light efficiency of a display panel.

In an embodiment, the barrier layer CAP1 includes a first layer CAP1-1, a second layer CAP1-2, and a third layer CAP1-3 sequentially stacked from the low refractive layer LR. The first layer CAP1-1, the second layer CAP1-2, and the third layer CAP1-3 each include silicon oxynitride.

The first layer CAP1-1 is disposed adjacent to the low refractive layer LR and corresponds to a silicon oxynitride layer having a relatively high amount of oxygen. The first layer CAP1-1 may be a layer directly disposed below the low refractive layer LR. The first layer CAP1-1 may contact the low refractive layer LR. An upper surface U1 of the first layer CAP1-1 may contact the lower surface LR-L of the low refractive layer LR.

The first layer CAP1-1 is a layer having a low amount of nitrogen, and the first layer CAP1-1 has nitrogen in an amount of less than about 1 at%. The first layer CAP1-1 may have, for example, nitrogen in an amount of about 0.1 at% to about 0.7 at%. Silicon oxynitride included in the first layer CAP1-1 has a composition ratio of nitrogen in an amount of less than about 1 at%, oxygen in an amount of about 45 at% to about 70 at%, and silicon in an amount of about 30 at% to about 55 at%. Silicon oxynitride included in the first layer CAP1-1, for example, may have a composition ratio of nitrogen in an amount of 1 at% or less, oxygen in an amount of about 58 at% to about 70 at%, and silicon in an amount of about 30 at% to about 42 at%. The first layer CAP1-1 has a relatively low concentration of nitrogen atom composition, and thus, film degeneration may be prevented at high temperature and high humidity. In addition, defects such as staining and lifting are not caused and outgas is less emitted.

The second layer CAP1-2 is disposed on the first layer CAP1-1 and corresponds to a silicon oxynitride layer having a relatively high amount of nitrogen. The second layer CAP1-2 may be a layer disposed spaced apart from the low refractive layer LR with the first layer CAP1-1 therebetween. The second layer CAP1-2 may be a layer directly disposed below the first layer CAP1-1. The second layer CAP1-2 may contact the first layer CAP1-1. An upper surface U2 of the second layer CAP1-2 may contact the lower surface L1 of the first layer CAP1-1.

The second layer CAP1-2 is a layer having a high amount of nitrogen, and the second layer CAP1-2 has nitrogen in an amount of about 3 at% to about 30 at%. The second layer CAP1-2 may have nitrogen in an amount of, for example, about 15 at% to about 22 at%. Silicon oxynitride included in the second layer CAP1-2 has a composition ratio of nitrogen in an amount of about 3 at% to about 30 at%, oxygen in an amount of about 25 at% to about 50 at%, and silicon in an amount of about 30 at% to about 55 at%. Silicon oxynitride included in the first layer CAP1-2, for example, may have a composition ratio of nitrogen in an amount of about 15 at% to about 22 at%, oxygen in an amount of about 38 at% to about 48 at%, and silicon in an amount of about 30 at% to about 42 at%. The second layer CAP1-2 has a relatively high concentration of nitrogen atom composition, and thus has high robustness to plasma. The optical structure layer OSL includes the barrier layer CAP1 including the second layer CAP1-2, and may thus prevent organic materials included the low refractive layer LR from being damaged by plasma and the like applied when the barrier layer CAP1 is formed. In addition, as the second layer CAP1-2 satisfies the composition ratio described above, an amount of surface moisture adsorption is reduced, so that the second layer CAP1-2 may have excellent moisture barrier properties.

The third layer CAP1-3 is disposed adjacent to the second layer CAP1-2 and corresponds to a silicon oxynitride layer having a relatively high amount of oxygen. The third layer CAP1-3 may be a layer directly disposed below the second layer CAP1-2. The third layer CAP1-3 may contact the second layer CAP1-2. An upper surface U3 of the third layer CAP1-3 may contact the lower surface L2 of the second layer CAP1-2. Meanwhile, the third layer CAP1-3 may be directly disposed on the light control pattern CCP-G disposed therebelow. The third layer CAP1-3 may contact the light control pattern CCP-G disposed therebelow. A lower surface L3 of the third layer CAP1-3 may contact an upper surface of the light control pattern CCP-G.

The third layer CAP1-3 is a layer having a low amount of nitrogen, and the third layer CAP1-3 has nitrogen in an amount of less than about 3.2 at%. The third layer CAP1-3 may have, for example, nitrogen in an amount of about 0.1 at% to about 3 at%. Silicon oxynitride included in the third layer CAP1-3 has a composition ratio of nitrogen in an amount of less than about 3.2 at%, oxygen in an amount of about 45 at% to about 70 at%, and silicon in an amount of about 30 at% to about 55 at%. Silicon oxynitride included in the third layer CAP1-3, for example, may have a composition ratio of nitrogen in an amount of 3 at% or less, oxygen in an amount of about 58 at% to about 70 at%, and silicon in an amount of about 30 at% to about 42 at%. The third layer CAP1-3 has a relatively low concentration of nitrogen atom composition, and thus, film degeneration may be prevented at high temperature and high humidity. In addition, defects such as staining and lifting are not caused and outgas is less emitted. In addition, the third layer CAP1-3 satisfies the composition ratio described above and thus has a low refractive index, so that a display panel may have improved light emission efficiency.

In silicon oxynitride included in the first layer CAP1-1 and silicon oxynitride included in the second layer CAP1-2, the second layer CAP1-2 has an amount of nitrogen, which is 3 times to 60 times greater than the first layer CAP1-1. For example, the second layer CAP1-2 may have an amount of nitrogen, which is 15 times to 40 times greater than the first layer CAP1-1. In the barrier layer CAP1, the first layer CAP1-1 having a relatively low amount of nitrogen may be disposed adjacent to the low refractive layer LR to prevent film degeneration at high temperature and high humidity, and moisture entering from the low refractive layer LR may be effectively blocked.

The barrier layer CAP1 may have a total thickness of about 2000 Å to about 12000 Å.

The first layer CAP1-1 may have a thickness d1 of about 500 angstrom (Å) to about 5,000 angstroms (Å). When the thickness d1 of the first layer CAP1-1 is less than about 500 Å, film degeneration in which the barrier layer CAP1 expands at high temperature and high humidity may be caused, resulting in degradation in moisture barrier properties of the barrier layer CAP1. When the thickness d1 of the first layer CAP1-1 is greater than about 5000 Å, a film having a uniform thickness and composition may be hardly achieved in a process to degrade film properties, and the thick barrier layer CAP1 may cause greater stress applied to the optical structure layer OSL to damage a substrate.

The second layer CAP1-2 may have a thickness d2 of about 600 angstrom (Å) to about 5,000 angstroms (Å). When the thickness d2 of the second layer CAP1-2 is less than about 600 Å, the low refractive layer LR may be damaged by plasma applied in the film forming process. When the thickness d2 of the second layer CAP1-2 is greater than about 5000 Å, a film having a uniform thickness and composition may be hardly achieved in a process to degrade film properties, and the thick barrier layer CAP1 may cause greater stress applied to the optical structure layer OSL to damage a substrate.

The third layer CAP1-3 may have a thickness d3 of about 500 angstrom (Å) to about 5,000 angstroms (Å). When the thickness d3 of the third layer CAP1-3 is less than about 500 Å, recycling of light through the third layer CAP1-3 having a low refractive index may not be achieved. When the thickness d3 of the third layer CAP1-3 is greater than about 5000 Å, a film having a uniform thickness and composition may be hardly achieved in a process to degrade film properties, and the thick barrier layer CAP1 may cause greater stress applied to the optical structure layer OSL to damage a substrate.

The third layers CAP1-3 included in the barrier layer CAP1 may have a lower refractive index than adjacent layers. The third layer CAP1-3 may have a lower refractive index than the adjacent second layer CAP1-2 and the light control pattern CCP-G.

The third layer CAP1-3 may have a refractive index of about 1.3 to about 1.5. For example, the third layer CAP1-3 may have a refractive index of about 1.3 to about 1.5 with respect to light in a wavelength range of about 400 nm to about 700 nm.

The first layer CAP1-1 may have a refractive index of about 1.3 to about 1.5. For example, the first layer CAP1-1 may have a refractive index of about 1.3 to about 1.5 with respect to light in a wavelength range of about 400 nm to about 700 nm.

The second layer CAP1-2 may have a refractive index of about 1.4 to about 1.8. For example, the second layer CAP1-2 may have a refractive index of about 1.4 to about 1.8 with respect to light in a wavelength range of about 400 nm to about 700 nm.

In an embodiment, the third layer CAP1-3 included in the barrier layer CAP1 may have a lower refractive index than the adjacent light control pattern CCP-G, and a difference in the refractive index between the third layer CAP1-3 and the light control pattern CCP-G may be about 0.1 to about 0.25. For example, the difference in the refractive index between the third layer CAP1-3 and the light control pattern CCP-G may be about 0.15 to about 0.2. In an embodiment, the light control pattern CCP-G may have a refractive index of about 1.5 to about 1.7.

In an embodiment, the refractive index of the third layer CAP1-3 included in the barrier layer CAP1 may be regulated to be lower than the refractive index of the light control pattern CCP-G, while the difference in the refractive index between the third layer CAP1-3 and the light control pattern CCP-G may be regulated to 0.1 or greater. Specifically, as described above, the third layer CAP1-3 according to an embodiment may regulate the composition ratio of silicon, oxygen, and nitrogen to set the third layer CAP1-3 to have a lower refractive index than the light control pattern CCP-G by 0.1 or greater. Accordingly, the light control pattern CCP-G may have greater light extraction efficiency, and reflection light may be prevented from entering the light control pattern CCP-G.

In an embodiment, the first layer CAP1-1 included in the barrier layer CAP1 may have a higher refractive index than the adjacent low refractive layer LR. The low refractive layer may have a low refractive index of about 1.3 or less with respect to light in a wavelength range of about 400 nm to about 700 nm. The first layer CAP1-1 may have a higher refractive index than the adjacent low refractive layer LR, and the low refractive layer LR may thus have greater light extraction efficiency and anti-reflection properties.

The light control layer CCL according to an embodiment may further include an additional barrier layer CAP2. The additional barrier layer CAP2 may be disposed below the light control pattern CCP-G. More specifically, the additional barrier layer CAP2 may be disposed between the light control pattern CCP-G and the filling layer FML.

Like the barrier layer CAP1, the additional barrier layer CAP2 may include silicon oxynitride. A composition ratio of silicon, oxygen, and nitrogen in the additional barrier layer CAP2 including silicon oxynitride may be in the same range as that of any one of a plurality of layers included in the barrier layer CAP1 described above. The additional barrier layer CAP2 may include silicon oxynitride, and, like the first layer CAP1-1, may have a composition ratio of nitrogen in an amount of about less than about 1 at%, oxygen in an amount of about 45 at% to about 70 at%, and silicon in an amount of about 30 at% to about 55 at%. However, the embodiment of the inventive concept is not limited thereto, and the additional barrier layer CAP2 includes silicon oxynitride, but may have a composition ratio in a range different from the composition ratio of silicon, oxygen, and nitrogen of the plurality of layers included in the barrier layer CAP1. Alternatively, the additional barrier layer CAP2 may include silicon oxide or silicon nitride instead of silicon oxynitride. The additional barrier layer CAP2 may also include titanium oxide or aluminum oxide.

The additional barrier layer CAP2 may have a lower refractive index than the adjacent light control pattern CCP-G. The additional barrier layer CAP2 may have a refractive index of about 1.3 to about 1.8. For example, the additional barrier layer CAP2 may have a refractive index of about 1.4 to about 1.5 with respect to light in a wavelength range of about 400 nm to about 700 nm.

In an embodiment, the additional barrier layer CAP2 may have a lower refractive index than the adjacent light control pattern CCP-G, and a difference in the refractive index between the additional barrier layer CAP2 and the light control pattern CCP-G may be about 0.1 to about 0.25. For example, the difference in the refractive index between the additional barrier layer CAP2 and the light control pattern CCP-G may be about 0.15 to about 0.2. In an embodiment, the light control pattern CCP-G may have a refractive index of about 1.6 to about 1.95. Accordingly, total reflection of light moving from the light control pattern CCP-G toward the additional barrier layer CAP2 may be induced, and thus light traveling in a lower direction may be recycled. Accordingly, the light control pattern CCP-G may have greater light conversion efficiency, and when the light control pattern CCP-G is applied to the display panel, the display panel may have improved display efficiency.

The additional barrier layer CAP2 according to an embodiment has a lower refractive index than the filling layer FML, while a difference in the refractive index between the additional barrier layer CAP2 and the filling layer FML may be regulated to about 0.1 or less. Specifically, the additional barrier layer CAP2 according to an embodiment regulates the composition ratio of silicon, oxygen, and nitrogen as described above, so that the additional barrier layer CAP2 may be regulated to have a lower refractive index than the filling layer FML, but the difference may be regulated to be within a range of about 0.1 or less. Accordingly, an issue that a path of light traveling from the filling layer FML toward the additional barrier layer CAP2 is changed through refraction and total reflection and thus the light fails to travel toward the light control pattern CCP-G may be prevented.

The additional barrier layer CAP2 may have a thickness of about 2000 Å to about 12000 Å. The additional barrier layer CAP2 may have a thickness d2 of, for example, about 4000 Å to about 8000 Å. When the thickness of the additional barrier layer CAP2 is less than about 2000 Å, moisture and oxygen barrier properties are reduced, and moisture may thus penetrate the light control pattern CCP-G, and durability is reduced, resulting in defects such as lifting or film breakage. When the thickness of the additional barrier layer CAP2 is greater than about 12000 Å, a film having a uniform thickness and composition may be hardly achieved in a process to degrade film properties, and the thick additional barrier layer CAP2 may cause greater stress applied to the optical structure layer OSL to damage a substrate.

The barrier layer CAP1 according to an embodiment of the inventive concept has a multi-layer structure including silicon oxynitride, and differently regulates an amount of nitrogen of each layer to exhibit excellent moisture and oxygen barrier properties, excellent film durability at high temperature and high humidity so as to prevent defects such as degeneration and cracking of the film due to external factors. In addition, the refractive index of the barrier layer CAP1 may be regulated to correspond to the refractive index of adjacent layers to improve the light conversion efficiency of the light control pattern. More specifically, the barrier layer CAP1 includes a structure in which the first layer CAP1-1 having a relatively low amount of nitrogen, the second layer CAP1-2 having a relatively high amount of nitrogen, and the third layers CAP1-3 having a low amount of nitrogen and the having a refractive index regulated to be low are sequentially stacked, and accordingly, film degeneration may be prevented at high temperature and high humidity, moisture entering from the low refractive layer LR may be effectively blocked, and damage to the low refractive layer LR due to plasma applied when the barrier layer CAP1 is formed may be prevented. In addition, the light emission efficiency of the optical structure layer OSL and the display panel DP including the barrier layer CAP1 may be improved through the third layer CAP1-3 having a low refractive index.

The low refractive layer LR may be disposed above the barrier layer CAP in the third direction DR3 and may have a structure in which a plurality of hollow particles are dispersed in an organic base layer. As shown in FIG. 6B, the low refractive layer LR may include a base resin PY and a plurality of hollow particles VD dispersed in the base resin PY. The low refractive layer LR may include the plurality of hollow particles VD and may thus have a low refractive index.

With respect to a total weight of the low refractive layer LR, the base resin PY may have a weight of about 50 wt% to about 90 wt%. The base resin PY may include at least one of an acrylic-based resin, a silicone-based resin, or an epoxy-based resin. For example, the base resin PY may include silicon acrylate.

In an embodiment, the hollow particles VD may be derived from porogen. The low refractive layer LR may be formed from a composition in which a polymer resin and porogen are mixed. The base resin PY may be formed by solidifying the polymer resin of the composition, and the hollow particles VD may be formed by thermally decomposing the porogen. The hollow particles VD formed from the porogen may have a spherical shape. The hollow particles VD may be in a vacuum or may have a very small amount of gas. Alternatively, the hollow particles VD may each be filled with air or liquid.

With respect to the total weight of the low refractive layer LR, the porogen may be provided in an amount of about 10 wt% to about 40 wt%. The low refractive layer LR including the hollow particles VD formed from the porogen in an amount of about 10 wt% to about 30 wt% satisfies the refractive index range of the low refractive layer LR according to an embodiment, and may exhibit excellent durability.

Although not shown, the low refractive layer LR may further include additional materials such as inorganic particles in addition to the base resin PY and hollow particles VD. The inorganic particles may contain at least one of SiO2, MgF2, or Fe3O4.

The low refractive layer LR may be formed through slit coating, spin coating, roll coating, spray coating, or inkjet printing. However, this is presented as an example, and the method of forming the low refractive layer LR is not limited thereto. The low refractive layer LR may be formed using various methods such as a transfer method.

The low refractive layer LR may have a lower refractive index than adjacent components. The low refractive layer LR may have a lower refractive index than each of the light control pattern CCP-G included in the light control layer CCL, and the barrier layer CAP1. In an embodiment, the low refractive layer LR may have a refractive index of about 1.21 to about 1.25. The low refractive layer LR may totally reflect some of the blue light emitted from the light control layer CCL toward the color filter layer CFL to be re-incident to the light control layer CCL. The low refractive layer LR having a refractive index of about 1.21 to about 1.25 may exhibit easy total reflection due to a difference in refractive index with the light control layer CCL.

The low refractive layer LR may have a haze value of less than about 0.40%. The low refractive layer LR having a haze value of less than about 0.40% may be optically transparent.

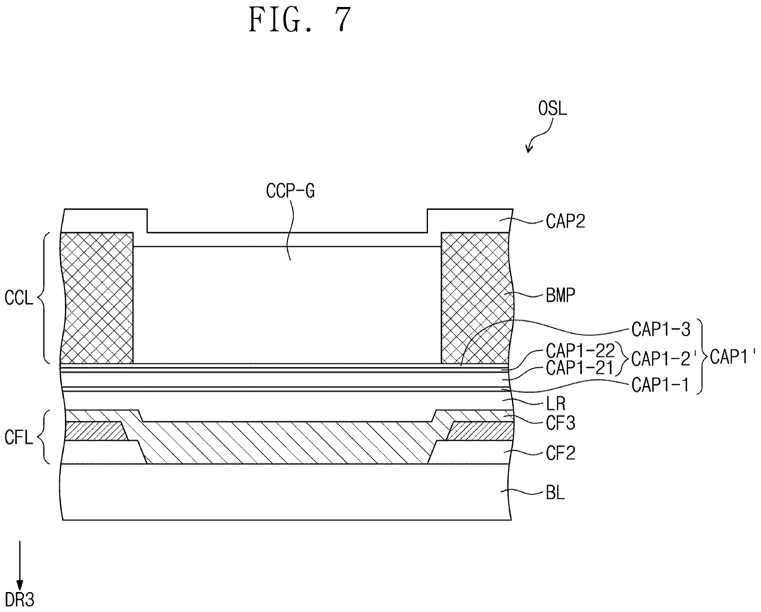

FIG. 7 is a cross-sectional view of some components of a display panel according to an embodiment of the inventive concept. In FIG. 7, in a cross section corresponding to FIG. 6A, an optical structure layer OSL of an embodiment different from the optical structure layer OSL shown in FIG. 6A is shown.

Referring to FIG. 7, a second layer CAP1-2' included in a barrier layer CAP1' may have a multi-layer structure. The second layer CAP1-2' may include a (2-1)-th layer CAP1-21 disposed adjacent to the first layer CAP1-1, and a (2-2)-th layer CAP1-22 disposed between the (2-1)-th layer CAP1-21 and the third layer CAP1-3. Meanwhile, although FIG. 7 shows, as an example, that the second layer CAP1-2' having a multi-layer structure includes two layers, but the embodiment of the inventive concept is not limited thereto, and the second layer CAP1-2' may include three or more layers.

The (2-1)-th layer CAP1-21 and (2-2)-th layer CAP1-22 each include silicon oxynitride, but may have a different composition ratio. The (2-1)-th layer CAP1-21 and the (2-2)-th layer CAP1-22 may have different amounts of nitrogen. The 2-1)-th layer CAP1-21 and the (2-2)-th layer CAP1-22 conform to the limited range of the composition ratio of silicon, oxygen and nitrogen of the second layer CAP1-2' described above, but may have a different composition ratio. The (2-1)-th layer CAP1-21 and the (2-2)-th layer CAP1-22 included in the second layer CAP1-2' may each have a composition ratio of silicon, oxygen, and nitrogen regulated to a different range to improve durability and optical properties of the optical structure layer OSL.

Table 1 below shows reliability evaluation results at high temperature and high humidity according to a stack structure of the display panel including the barrier layer described above and an amount of nitrogen for each layer. In Table 1, the barrier layer of Example is a barrier layer having a three-layer stack structure of a first layer, a second layer, and a third layer as shown in FIGS. 6A and 6B, and the barrier layer of Comparative Example corresponds to a barrier layer having a two-layer stack structure, unlike the barrier layer of Example. Meanwhile, in the reliability evaluation, after leaving it for 500 hours at 95 °C and 85% humidity, the presence of lifting of the barrier layer was observed, and a case where lifting was observed was evaluated as "defective.

**[Table 1]**

| Item | Stack structure | No. of defects/ No. of evaluations | Time for defect occurrence |
|---|---|---|---|
| Example 1 | 1st layer (N 0.5%) 700 Å / 2nd layer (N 19.1%) 1500 Å / 3rd layer (N 0.4%) 800 Å | 0:2 | - |
| Example 2 | 1st layer (N 0.5%) 500 Å / 2nd layer (N 19.1%) 800 Å / 3rd layer (N 0.4%) 700 Å | 0:2 | - |
| Comparative Example | 1st layer (N 19.1%) 2000 Å / 2nd layer (N 0.4%) 2000 Å | 16:21 | 500 hr(3)200 hr(4) |
| | | | 168 hr(6) |
| | | | 336 hr(3) |

Referring to the results of Table 1, it is seen that when the barrier layer of a two-layer structure as in Comparative Example was included, a number of defects in which the barrier layer was lifted at high temperature and high humidity were caused, but in Example, the lifting defect of the barrier layer was not caused at high temperature and high humidity. Based on the results of Table 1, it is seen that in the barrier layer of Example, as a first layer adjacent to a low refractive layer was formed with nitrogen in an amount of less than about 1 at%, lifting of the barrier layer due to moisture permeation was not caused at high temperature and high humidity reliability evaluation conditions. Accordingly, it is expected that an optical structure layer and a display panel including the barrier layer of Example have increased reliability and durability.

Although the present disclosure has been described with reference to a preferred embodiment of the inventive concept, it will be understood that the inventive concept should not be limited to these preferred embodiments but various changes and modifications can be made by those skilled in the art without departing from the spirit and scope of the present disclosure. Accordingly, the technical scope of the inventive concept is not intended to be limited to the contents set forth in the detailed description of the specification, but is intended to be defined by the appended claims.

### [Industrial Applicability]

Recent display devices have a wide viewing angle and excellent color reproducibility, including different types of light control patterns according to pixels to generate color images. Meanwhile, a display device including a light control pattern may have a light conversion efficiency reduced due to corrosion of a light emitting element such as a quantum dot included in the light control pattern by moisture and oxygen, and thus the display efficiency of the display panel may be reduced. According to an embodiment of the present invention, a display panel has excellent moisture and oxygen blocking properties of a barrier layer formed on one side of a light control pattern, and excellent film durability under high temperature and high humidity conditions, so that defects such as film degeneration and breakage due to external factors can be prevented. Therefore, the present invention, which provides a display panel according to an embodiment, has high industrial applicability.

## Claims

1. A display panel comprising:
a light emitting element that outputs source light, the light emitting element including:
a first electrode,
an emission layer disposed on the first electrode, and
a second electrode disposed on the emission layer; and
an optical structure layer disposed on the light emitting element,
wherein the optical structure layer includes:
a light control layer disposed on the light emitting element and including at least one light control pattern;
a low refractive layer disposed on the light control layer; and
a barrier layer disposed between the light control layer and the low refractive layer and including silicon oxynitride (SiON),
the barrier layer including:
a first layer disposed adjacent to the low refractive layer and having nitrogen in an amount of less than about 1 at%;
a second layer disposed spaced apart from the low refractive layer with the first layer therebetween, and having nitrogen in an amount of about 3 at% to about 30 at%; and
a third layer disposed spaced apart from the low refractive layer with the first layer and the second layer therebetween, and having nitrogen in an amount of less than about 3.2 at%.

2. The display panel of claim 1, wherein the third layer has a refractive index of about 1.3 to about 1.5 with respect to light in a wavelength range of about 400 nm to about 700 nm.

3. The display panel of claim 1, wherein:
the first layer is directly disposed on the low refractive layer;
the second layer is directly disposed on the first layer; and
the third layer is directly disposed on the second layer.

4. The display panel of claim 1, wherein the first layer has a thickness of about 500 angstrom (Å) or greater.

5. The display panel of claim 1, wherein the optical structure layer further includes a color filter layer spaced apart from the light control layer with the low refractive layer therebetween and including a plurality of color filters.

6. The display panel of claim 1, wherein the light control pattern comprises a first light control pattern configured to convert the source light into first light and a second light control pattern configured to transmit the source light, and
the first light control pattern comprises first quantum dots configured to convert the source light into the first light.

7. The display panel of claim 1, wherein the light control layer further comprises a bank disposed between the light control patterns, and
the barrier layer is directly disposed on one surface of the light control pattern and the bank.

8. The display panel of claim 1, wherein the low refractive layer comprises a base resin, and a plurality of hollow particles dispersed in the base resin.

9. The display panel of claim 1, wherein the low refractive layer has a refractive index of about 1.3 or less with respect to light in a wavelength range of about 400 nm to about 700 nm.

10. The display panel of claim 1, wherein the second layer comprises:
a (2-1)-th layer disposed adjacent to the first layer; and
a (2-2)-th layer disposed between the (2-1)-th layer and the third layer and having a different amount of nitrogen from the (2-1)-th layer.

11. The display panel of claim 1, wherein the optical structure layer further comprises an additional barrier layer spaced apart from the barrier layer with the light control layer therebetween, and
the additional barrier layer is directly disposed on one surface of the light control pattern.

12. The display panel of claim 1, further comprising a filling layer disposed between the light emitting element and the optical structure layer and covering the light emitting element.

13. The display panel of claim 1, wherein the first layer has a refractive index of about 1.3 to about 1.5 with respect to light in a wavelength range of about 400 nm to about 700 nm, and
the second layer has a refractive index of about 1.4 to about 1.8 with respect to light in a wavelength range of about 400 nm to about 700 nm.

14. The display panel of claim 1, wherein the third layer is in contact with one surface of the light control pattern.

15. The display panel of claim 1, wherein the light emitting element comprises a plurality of light emitting stacks disposed between the first electrode and the second electrode and each including the emission layer,
the plurality of light emitting stacks including:
a first light emitting stack disposed on the first electrode and including a first emission layer,
a charge generation layer disposed on the first stack, and
a second light emitting stack disposed on the charge generation layer and including a second emission layer, and
the first emission layer emitting light of a different color from the second emission layer.

16. A display panel comprising:
a light emitting element that outputs source light, the light emitting element including:
a first electrode,
an emission layer disposed on the first electrode, and
a second electrode disposed on the emission layer; and
an optical structure layer disposed on the light emitting element, wherein the optical structure layer includes:
a light control layer disposed on the light emitting element and including at least one light control pattern;
a low refractive layer disposed on the light control layer; and
a barrier layer disposed between the light control layer and the low refractive layer,
the barrier layer is sequentially disposed from the low refractive layer and includes a first layer, a second layer, and a third layer each including silicon oxynitride (SiON),
the second layer has an amount of nitrogen, which is 3 times to 60 times greater than the first layer, and
the third layer has nitrogen in an amount of less than about 3.2 at%.

17. The display panel of claim 16, wherein:
the first layer is directly disposed below the refractive layer;
the second layer is directly disposed below the first layer; and
the third layer is directly disposed below the second layer.

18. A display panel comprising:
a light emitting element that outputs source light, the light emitting element including:
a first electrode,
an emission layer disposed on the first electrode, and
a second electrode disposed on the emission layer; and
an optical structure layer disposed on the light emitting element, wherein the optical structure layer includes:
a light control layer disposed on the light emitting element and including at least one light control pattern;
a low refractive layer disposed on the light control layer; and
a barrier layer disposed between the light control layer and the low refractive layer and including silicon oxynitride (SiON),
the barrier layer includes:
a first layer directly disposed below the low refractive layer and having nitrogen in an amount of less than about 1 at%;
a second layer directly disposed below the first layer and having nitrogen in an amount of about 3 at% to about 30 at%; and
a third layer directly disposed below the second layer, and
the light control layer is directly disposed below the third layer.

19. The display panel of claim 18, wherein:
the first layer has a refractive index of about 1.3 to about 1.5 with respect to light in a wavelength range of about 400 nm to about 700 nm;
the second layer has a refractive index of about 1.4 to about 1.8 with respect to light in a wavelength range of about 400 nm to about 700 nm; and
the third layer has a refractive index of about 1.3 to about 1.5 with respect to light in a wavelength range of about 400 nm to about 700 nm.

20. The display panel of claim 18, wherein:
the first layer has a thickness of about 500 angstrom (Å) or greater;
the second layer has a thickness of about 600 angstrom (Å) or greater; and
the third layer has a thickness of about 500 angstrom (Å) or greater.
